# EUROPEAN PATENT APPLICATION

(11) **EP 4 842 157 A1**
(43) Date of publication of application: **18.11.2026**
(21) Application number: 25747649.9
(22) Date of filing: 21.01.2025
(51) Int. Cl.: H10D 12/00, H10D 48/34, H10D 62/13

(54) **SEMICONDUCTOR DEVICE AND RELATED CIRCUIT, CHIP, ELECTRONIC DEVICE AND MANUFACTURING METHOD**

(30) Priority: 01.02.2024 CN 202410145204
(71) Applicant: Huawei Technologies Co., Ltd., Shenzhen, Guangdong 518129 (CN)
(72) Inventor: ZHAO, Qian, Shenzhen, Guangdong 518129 (CN); MANABU, Takei, Shenzhen, Guangdong 518129 (CN); HAMADA, Kimimori, Shenzhen, Guangdong 518129 (CN); NING, Runtao, Shenzhen, Guangdong 518129 (CN); YANG, Wentao, Shenzhen, Guangdong 518129 (CN)
(74) Representative: Goddar, Heinz J.
(86) International application number: PCT/CN2025/073691
(87) International publication number: WO 2025/162077

(57) **Abstract**

A semiconductor device, a related circuit, a chip, an electronic device, and a preparation method are disclosed. The semiconductor device includes a first semiconductor layer (310) and a second semiconductor layer (320), where the first semiconductor layer (310) includes a plurality of pillars (313); and the second semiconductor layer (320) is disposed above the first semiconductor layer (310). The semiconductor device is divided, in a first direction, into an IGBT region, a diode region, and a MOSFET region. The semiconductor device further includes a third semiconductor layer (330) and a fourth semiconductor layer (340), where the third semiconductor layer (330) is disposed below the first semiconductor layer (310) and is located in the diode region and the MOSFET region; and the fourth semiconductor layer (340) is disposed below the first semiconductor layer (310) and is located in the IGBT region. The semiconductor device further includes at least one first conductive material region (323), and the at least one first conductive material region (323) is located in the diode region. The semiconductor device exhibits good synchronous rectification performance.

## Description

This application claims priority to Chinese Patent Application No. 202410145204.8, filed with the China National Intellectual Property Administration on February 1, 2024 and entitled "SEMICONDUCTOR DEVICE, RELATED CIRCUIT, CHIP, ELECTRONIC DEVICE, AND PREPARATION METHOD", which is incorporated herein by reference in its entirety.

### TECHNICAL FIELD

This application relates to the field of semiconductor technologies, and more specifically, to a semiconductor device, a related circuit, a chip, an electronic device, and a preparation method.

### BACKGROUND

Insulated-gate bipolar transistors (insulated-gate bipolar transistors, IGBTs) combine advantages of metal-oxide-semiconductor field-effect transistors (metal-oxide-semiconductor field-effect transistors, MOSFETs) and bipolar junction transistors (BJTs), and have been widely used in medium- and high-power power electronic apparatuses in fields such as new energy vehicles, smart grids, rail transportation, industrial control, communication power supplies, and consumer electronics.

To improve power density of the IGBT, an effective solution is to integrate the IGBT and a diode into a chip to form a reverse conduction IGBT (reverse conduction IGBT, RC-IGBT). The RC-IGBT chip integrates functions of the IGBT and the diode in a single-chip form, thereby replacing two chips with one chip. This integrated design reduces the required chip area and enables devices of a same package size to provide higher power density. In addition, during operation of the RC-IGBT, an IGBT region and a diode region may assist each other in heat dissipation. With such a mutually assisted design, heat can be conducted and dissipated more effectively, thereby reducing overall thermal resistance and improving thermal performance of a system.

### SUMMARY

This application provides a semiconductor device, a related circuit, a chip, an electronic device, and a preparation method. Embodiments of this application provide a semiconductor device having better synchronous rectification performance.

According to a first aspect, an embodiment of this application provides a semiconductor device, including a first semiconductor layer and a second semiconductor layer, where a conductivity type of the first semiconductor layer is a first conductivity type, the first semiconductor layer includes a plurality of pillars, the plurality of pillars are arranged in a first direction, the first direction is perpendicular to a thickness direction of the semiconductor device, and a conductivity type of the pillar is a second conductivity type; the second semiconductor layer is disposed above the first semiconductor layer, and a conductivity type of the second semiconductor layer is the second conductivity type; and the semiconductor device is divided, in the first direction, into an IGBT region for forming an insulated-gate bipolar transistor IGBT, a diode region for forming a diode, and a MOSFET region for forming a metal-oxide-semiconductor field-effect transistor MOSFET; the semiconductor device further includes a third semiconductor layer and a fourth semiconductor layer, where the third semiconductor layer is disposed below the first semiconductor layer and is located in the diode region and the MOSFET region, and a conductivity type of the third semiconductor layer is the first conductivity type; and the fourth semiconductor layer is disposed below the first semiconductor layer and is located in the IGBT region, and a conductivity type of the fourth semiconductor layer is the second conductivity type; and the semiconductor device further includes at least one first conductive material region, and the at least one first conductive material region is located in the diode region.

Optionally, the first conductivity type is different from the second conductivity type. For example, the first conductivity type may be an N type, and the second conductivity type may be a P type. For another example, the first conductivity type may be a P type, and the second conductivity type may be an N type. With reference to the foregoing technical solution, it is assumed that the first conductivity type is the N type, and the second conductivity type is the P type. In this case, when a forward voltage is applied to the diode region, an N-type cathode region of the diode is for injecting electrons from a cathode direction. If a conductive material region located in the diode region is at a same potential as an emitter, formation of a channel can be avoided. When the forward voltage is applied to a gate, a hole may be injected from the second semiconductor layer into an N-type region of the first semiconductor layer. This can reduce a voltage drop in a synchronous rectification (synchronous rectification) mode, thereby improving synchronous rectification performance of the semiconductor device.

In addition, an area proportion of the diode region to a total region (that is, the diode region+the MOSFET region+the IGBT region) affects a current conduction characteristic of the diode in a reverse bias condition and a current conduction characteristic of the IGBT and the MOSFET in a forward bias condition. A larger proportion of the diode region to the total region indicates a smaller conduction voltage drop under a high current during reverse conduction. The larger proportion of the diode region to the total region indicates a larger conduction voltage drop under a high current and a low current during forward conduction.

With reference to the first aspect, in a possible implementation of the first aspect, the semiconductor device further includes at least one first semiconductor region, at least one second semiconductor region, at least one second conductive material region, and at least one third conductive material region, where the at least one third conductive material and the at least one first semiconductor region are located in the IGBT region; the at least one second conductive material region and the at least one second semiconductor region are located in the MOSFET region; and a conductivity type of the first semiconductor region and a conductivity type of the second semiconductor region are the first conductivity type.

With reference to the first aspect, in a possible implementation of the first aspect, the first conductive material region includes a first trench, the first trench is filled with a first conductive material, and the first trench penetrates the second semiconductor layer and is in contact with a first semiconductor layer and/or a pillar that are/is located in the diode region; the second conductive material region includes a second trench, the second trench is filled with a second conductive material, and the second trench penetrates the second semiconductor layer and is in contact with a first semiconductor layer and/or a pillar that are/is located in the MOSFET region; and the third conductive material region includes a third trench, the third trench is filled with a third conductive material, and the third trench penetrates the second semiconductor layer and is in contact with a first semiconductor layer and/or a pillar that are/is located in the IGBT region.

With reference to the first aspect, in a possible implementation of the first aspect, the semiconductor device further includes at least one fourth conductive material region, and the at least one fourth conductive material region is located in the IGBT region.

With reference to the first aspect, in a possible implementation of the first aspect, the semiconductor device further includes at least one fifth conductive material region, and the at least one fifth conductive material region is located in the MOSFET region.

With reference to the first aspect, in a possible implementation of the first aspect, the IGBT region, the diode region, and the MOSFET region are sequentially arranged in the first semiconductor layer in the first direction.

With reference to the first aspect, in a possible implementation of the first aspect, the MOSFET region includes a first MOSFET region and a second MOSFET region, and the IGBT region, the first MOSFET region, the diode region, and the second MOSFET region are sequentially arranged in the first semiconductor layer in the first direction.

With reference to the first aspect, in a possible implementation of the first aspect, the semiconductor device further includes at least one floating region, the at least one floating region is in one-to-one correspondence with at least one of the pillars, and the floating region penetrates the second semiconductor layer and is in contact with the corresponding pillar.

With reference to the first aspect, in a possible implementation of the first aspect, the first semiconductor region and the second semiconductor region are located in a region of the second semiconductor layer facing away from the first semiconductor layer.

According to a second aspect, an embodiment of this application provides a semiconductor device, where the semiconductor device is divided, in a first direction, into an IGBT region for forming an insulated-gate bipolar transistor IGBT and a MOSFET region for forming a metal-oxide-semiconductor field-effect transistor MOSFET, the first direction, a second direction, and a third direction are perpendicular to each other, and the second direction is a thickness direction of the semiconductor device; and the MOSFET region includes a first semiconductor layer, a second semiconductor layer, a third semiconductor layer, and a fourth semiconductor layer, where a conductivity type of the first semiconductor layer is a first conductivity type, the first semiconductor layer includes a plurality of pillars, the plurality of pillars are arranged in the first direction, and a conductivity type of the pillar is a second conductivity type; a conductivity type of the second semiconductor layer is the second conductivity type, and the second semiconductor layer is disposed above the first semiconductor layer; a conductivity type of the third semiconductor layer is the first conductivity type, and the third semiconductor layer is disposed below the first semiconductor layer; the fourth semiconductor layer is disposed on a surface of the second semiconductor layer facing away from the first semiconductor layer, and the fourth semiconductor layer includes a first semiconductor region and a second semiconductor region that are disposed in parallel on two sides of the fourth semiconductor layer, a plurality of conductive material regions that are disposed in parallel, and a plurality of third semiconductor regions that are disposed in parallel, where the first semiconductor region and the second semiconductor region are parallel to the first direction, and a conductivity type of the first semiconductor region and a conductivity type of the second semiconductor region are the first conductivity type; the conductive material region is parallel to the third direction; and the third semiconductor region is parallel to the third direction, and a conductivity type of the third semiconductor region is the second conductivity type; and the fourth semiconductor layer further includes a fourth semiconductor region, the fourth semiconductor region is located between the third semiconductor region and the conductive material region, and a conductivity type of the fourth semiconductor region is the second conductivity type.

For the semiconductor device, when electrons are injected upward from the bottom of the MOSFET region, after being injected into the fourth semiconductor layer, the electrons continue to be injected into the first semiconductor region and the second semiconductor region that are disposed in parallel. Therefore, a transmission path of the electrons is longer than a side length of a drift region. In this case, a transverse voltage drop is generated. The transverse voltage drop causes a PN junction of a channel substrate (channel substrate, CS) layer to be forward-biased. A hole is injected from a fourth semiconductor region between the first semiconductor region and the second semiconductor region that are disposed in parallel, so that a body diode in the MOSFET region exhibits a lower voltage drop in a synchronous rectification mode. This can improve synchronous rectification performance of the semiconductor device.

With reference to the second aspect, in a possible implementation of the second aspect, the first semiconductor region is divided into a plurality of first sub-semiconductor regions by the plurality of third semiconductor regions that are disposed in parallel and the plurality of conductive material regions that are disposed in parallel; and the second semiconductor region is divided into a plurality of second sub-semiconductor regions by the plurality of third semiconductor regions that are disposed in parallel and the plurality of conductive material regions that are disposed in parallel.

With reference to the second aspect, in a possible implementation of the second aspect, the conductive material region includes a trench, the trench is filled with a conductive material, and the trench penetrates the second semiconductor layer.

With reference to the second aspect, in a possible implementation of the second aspect, an impurity concentration of the third semiconductor region is different from an impurity concentration of the fourth semiconductor region.

With reference to the second aspect, in a possible implementation of the second aspect, the MOSFET region further includes a fifth semiconductor layer, a conductivity type of the fifth semiconductor layer is the first conductivity type, and the fifth semiconductor layer is located between the first semiconductor layer and the second semiconductor layer.

With reference to the second aspect, in a possible implementation of the second aspect, the semiconductor device further includes a sixth semiconductor layer, the sixth semiconductor layer is located between the first semiconductor layer and the third semiconductor layer, and a conductivity type of the sixth semiconductor layer is the first conductivity type.

According to a third aspect, an embodiment of this application provides a power conversion circuit, including at least one semiconductor device according to any one of the first aspect or the possible implementations of the first aspect.

According to a fourth aspect, an embodiment of this application provides a power conversion circuit, including at least one semiconductor device according to any one of the second aspect or the possible implementations of the second aspect.

According to a fifth aspect, an embodiment of this application provides a chip, including at least one semiconductor device according to any one of the first aspect or the possible implementations of the first aspect.

According to a sixth aspect, an embodiment of this application provides a chip, including at least one semiconductor device according to any one of the second aspect or the possible implementations of the second aspect.

According to a seventh aspect, an embodiment of this application provides an electronic device, including at least one semiconductor device according to any one of the first aspect or the possible implementations of the first aspect.

According to an eighth aspect, an embodiment of this application provides an electronic device, including at least one semiconductor device according to any one of the second aspect or the possible implementations of the second aspect.

According to a ninth aspect, an embodiment of this application provides a transportation means, including at least one semiconductor device according to any one of the first aspect or the possible implementations of the first aspect. The transportation means may be a vehicle, for example, an electric vehicle, a hybrid vehicle, or an electric bicycle.

According to a tenth aspect, an embodiment of this application provides a transportation means, including at least one semiconductor device according to any one of the second aspect or the possible implementations of the second aspect. The transportation means may be a vehicle, for example, an electric vehicle, a hybrid vehicle, or an electric bicycle.

According to an eleventh aspect, an embodiment of this application provides a control method. The method includes: monitoring, when a current direction of the semiconductor device according to any one of the first aspect or the possible implementations of the first aspect is from an emitter to a collector, a current value of a main current of the semiconductor device at dead time; and keeping a gate of the semiconductor device in an off state when the current value of the main current is greater than a preset value; or turning on the gate of the semiconductor device after the dead time when the current value of the main current is less than or equal to the preset value.

According to a twelfth aspect, an embodiment of this application provides a control method. The method includes: monitoring, when a current direction of the semiconductor device according to any one of the second aspect or the possible implementations of the second aspect is from an emitter to a collector, a current value of a main current of the semiconductor device at dead time; and keeping a gate of the semiconductor device in an off state when the current value of the main current is greater than a preset value; or turning on the gate of the semiconductor device after the dead time when the current value of the main current is less than or equal to the preset value.

According to a thirteenth aspect, an embodiment of this application provides a control method. The method includes: determining a first voltage value and a second voltage value when a current direction of the semiconductor device according to any one of the first aspect or the possible implementations of the first aspect is from an emitter to a collector, where the first voltage value is a voltage value of a terminal voltage of the semiconductor device at dead time, and the second voltage value is a voltage value of the terminal voltage after a gate of the semiconductor device is turned on; and turning off the gate of the semiconductor device when a difference between the second voltage value and the first voltage value is greater than a preset value; or keeping the gate of the semiconductor device in an on state when the difference between the second voltage value and the first voltage value is not greater than the preset value.

According to a fourteenth aspect, an embodiment of this application provides a control method. The method includes: determining a first voltage value and a second voltage value when a current direction of the semiconductor device according to any one of the second aspect or the possible implementations of the second aspect is from an emitter to a collector, where the first voltage value is a voltage value of a terminal voltage of the semiconductor device at dead time, and the second voltage value is a voltage value of the terminal voltage after a gate of the semiconductor device is turned on; and turning off the gate of the semiconductor device when a difference between the second voltage value and the first voltage value is greater than a preset value; or keeping the gate of the semiconductor device in an on state when the difference between the second voltage value and the first voltage value is not greater than the preset value.

According to a fifteenth aspect, an embodiment of this application provides a manufacturing method for a semiconductor device, including: dividing, in a first direction, the semiconductor device into an IGBT region for forming an insulated-gate bipolar transistor IGBT, a diode region for forming a diode, and a MOSFET region for forming a metal-oxide-semiconductor field-effect transistor MOSFET; manufacturing a first semiconductor layer, where a conductivity type of the first semiconductor layer is a first conductivity type, the first semiconductor layer includes a plurality of pillars, the plurality of pillars are arranged in the first direction, the first direction is perpendicular to a thickness direction of the semiconductor device, and a conductivity type of the pillar is a second conductivity type; manufacturing a second semiconductor layer, where the second semiconductor layer is located above a first surface of the first semiconductor layer, and a conductivity type of the second semiconductor layer is the second conductivity type; manufacturing a third semiconductor layer, where the third semiconductor layer is located below a second surface of the first semiconductor layer and is located in the diode region and the MOSFET region, and a conductivity type of the third semiconductor layer is the first conductivity type; manufacturing a fourth semiconductor layer, where the fourth semiconductor layer is located below the second surface of first semiconductor layer and is located in the IGBT region, and a conductivity type of the fourth semiconductor layer is the second conductivity type; and manufacturing at least one first conductive material region, where the at least one first conductive material region is located in the diode region.

With reference to the fifteenth aspect, in a possible implementation of the fifteenth aspect, the method further includes manufacturing at least one first semiconductor region, at least one second semiconductor region, at least one second conductive material region, and at least one third conductive material region, where the at least one third conductive material region and the at least one first semiconductor region are located in the IGBT region; the at least one second conductive material region and the at least one second semiconductor region are located in the MOSFET region; and a conductivity type of the first semiconductor region and a conductivity type of the second semiconductor region are the first conductivity type.

With reference to the fifteenth aspect, in a possible implementation of the fifteenth aspect, manufacturing the first conductive material region includes forming a first trench, where the first trench penetrates the second semiconductor layer and is in contact with a first semiconductor layer and/or a pillar that are/is located in the diode region, and the first trench is filled with a first conductive material; manufacturing the second conductive material region includes forming a second trench, where the second trench penetrates the second semiconductor layer and is in contact with a first semiconductor layer and/or a pillar that are/is located in the MOSFET region, and the second trench is filled with a second conductive material; and manufacturing the third conductive material region includes forming a third trench, where the third trench penetrates the second semiconductor layer and is in contact with a first semiconductor layer and/or a pillar that are/is located in the IGBT region, and the third trench is filled with a third conductive material.

With reference to the fifteenth aspect, in a possible implementation of the fifteenth aspect, the method further includes manufacturing at least one fourth conductive material region, where the at least one fourth conductive material region is located in the IGBT region.

With reference to the fifteenth aspect, in a possible implementation of the fifteenth aspect, the method further includes manufacturing at least one fifth conductive material region, where the at least one fifth conductive material region is located in the MOSFET region.

With reference to the fifteenth aspect, in a possible implementation of the fifteenth aspect, the IGBT region, the diode region, and the MOSFET region are sequentially arranged in the first semiconductor layer in the first direction.

With reference to the fifteenth aspect, in a possible implementation of the fifteenth aspect, the MOSFET region includes a first MOSFET region and a second MOSFET region, and the IGBT region, the first MOSFET region, the diode region, and the second MOSFET region are sequentially arranged in the first semiconductor layer in the first direction.

With reference to the fifteenth aspect, in a possible implementation of the fifteenth aspect, the method further includes manufacturing at least one floating region, where the at least one floating region is in one-to-one correspondence with at least one of the pillars, and the floating region penetrates the second semiconductor layer and is in contact with the corresponding pillar.

With reference to the fifteenth aspect, in a possible implementation of the fifteenth aspect, the first semiconductor region and the second semiconductor region are manufactured in a region of the second semiconductor layer facing away from the first semiconductor layer.

According to a sixteenth aspect, an embodiment of this application provides a manufacturing method for a semiconductor device, including: dividing, in a first direction, the semiconductor device into an IGBT region for forming an insulated-gate bipolar transistor IGBT and a MOSFET region for forming a metal-oxide-semiconductor field-effect transistor MOSFET, where the first direction, a second direction, and a third direction are perpendicular to each other, and the second direction is a thickness direction of the semiconductor device; manufacturing a first semiconductor layer, where the first semiconductor layer is located in the MOSFET region, a conductivity type of the first semiconductor layer is a first conductivity type, the first semiconductor layer includes a first surface and a second surface that are opposite to each other, the first semiconductor layer further includes a plurality of pillars, the plurality of pillars are arranged in the first direction, and a conductivity type of the pillar is a second conductivity type; manufacturing a second semiconductor layer, where the second semiconductor layer is located in the MOSFET region, a conductivity type of the second semiconductor layer is the second conductivity type, and the second semiconductor layer is disposed above the first surface of the first semiconductor layer; manufacturing a third semiconductor layer, where the third semiconductor layer is located in the MOSFET region, a conductivity type of the third semiconductor layer is the first conductivity type, and the third semiconductor layer is disposed below the second surface of the first semiconductor layer; and manufacturing a fourth semiconductor layer, where the fourth semiconductor layer is located in the MOSFET region, the fourth semiconductor layer is disposed on a surface of the second semiconductor layer facing away from the first semiconductor layer. The fourth semiconductor layer includes a first semiconductor region and a second semiconductor region that are disposed in parallel on two sides of the fourth semiconductor layer, a plurality of conductive material regions that are disposed in parallel, and a plurality of third semiconductor regions that are disposed in parallel, where the first semiconductor region and the second semiconductor region are parallel to the first direction, and a conductivity type of the first semiconductor region and a conductivity type of the second semiconductor region are the first conductivity type; the conductive material region is parallel to the third direction; and the third semiconductor region is parallel to the third direction, and a conductivity type of the third semiconductor region is the second conductivity type. The fourth semiconductor layer further includes a fourth semiconductor region, the fourth semiconductor region is located between the third semiconductor region and the conductive material region, and a conductivity type of the fourth semiconductor region is the second conductivity type.

With reference to the sixteenth aspect, in a possible implementation of the sixteenth aspect, the first semiconductor region is divided into a plurality of first sub-semiconductor regions by the plurality of third semiconductor regions that are disposed in parallel and the plurality of conductive material regions that are disposed in parallel; and the second semiconductor region is divided into a plurality of second sub-semiconductor regions by the plurality of third semiconductor regions that are disposed in parallel and the plurality of conductive material regions that are disposed in parallel.

With reference to the sixteenth aspect, in a possible implementation of the sixteenth aspect, manufacturing the conductive material region includes forming a trench, where the trench penetrates the second semiconductor layer, and the trench is filled with a conductive material.

With reference to the sixteenth aspect, in a possible implementation of the sixteenth aspect, manufacturing the fourth semiconductor layer includes: doping an impurity at a first concentration in the third semiconductor region; and doping an impurity at a second concentration in the fourth semiconductor region, where the first concentration is different from the second concentration.

With reference to the sixteenth aspect, in a possible implementation of the sixteenth aspect, the method further includes manufacturing a fifth semiconductor layer, where the fifth semiconductor layer is located in the MOSFET region, a conductivity type of the fifth semiconductor layer is the first conductivity type, and the fifth semiconductor layer is located between the first semiconductor layer and the second semiconductor layer.

With reference to the sixteenth aspect, in a possible implementation of the sixteenth aspect, the method further includes manufacturing a sixth semiconductor layer, where the sixth semiconductor layer is located between the first semiconductor layer and the third semiconductor layer, and a conductivity type of the sixth semiconductor layer is the first conductivity type.

According to a seventeenth aspect, an embodiment of this application provides a computer device. The computer device includes a unit configured to implement any one of the fifteenth aspect or the possible implementations of the fifteenth aspect.

According to an eighteenth aspect, an embodiment of this application provides a computer device. The computer device includes a processor. The processor is configured to be coupled to a memory, and read and execute instructions and/or program code in the memory, to perform any one of the fifteenth aspect or the possible implementations of the fifteenth aspect.

According to a nineteenth aspect, an embodiment of this application provides a chip system. The chip system includes a logic circuit. The logic circuit is configured to be coupled to an input/output interface, and transmit data through the input/output interface, to perform any one of the fifteenth aspect or the possible implementations of the fifteenth aspect.

According to a twentieth aspect, an embodiment of this application provides a computer-readable storage medium. The computer-readable storage medium stores program code. When the program code stored in the computer storage medium is run on a computer, the computer is caused to perform any one of the fifteenth aspect or the possible implementations of the fifteenth aspect.

According to a twenty-first aspect, an embodiment of this application provides a computer program product. The computer program product includes computer program code. When the computer program code is run on a computer, the computer is caused to perform any one of the fifteenth aspect or the possible implementations of the fifteenth aspect.

According to a twenty-second aspect, an embodiment of this application provides a computer device. The computer device includes a unit configured to implement any one of the sixteenth aspect or the possible implementations of the sixteenth aspect.

According to a twenty-third aspect, an embodiment of this application provides a computer device. The computer device includes a processor. The processor is configured to be coupled to a memory, and read and execute instructions and/or program code in the memory, to perform any one of the sixteenth aspect or the possible implementations of the sixteenth aspect.

According to a twenty-fourth aspect, an embodiment of this application provides a chip system. The chip system includes a logic circuit. The logic circuit is configured to be coupled to an input/output interface, and transmit data through the input/output interface, to perform any one of the sixteenth aspect or the possible implementations of the sixteenth aspect.

According to a twenty-fifth aspect, an embodiment of this application provides a computer-readable storage medium. The computer-readable storage medium stores program code. When the program code stored in the computer storage medium is run on a computer, the computer is caused to perform any one of the sixteenth aspect or the possible implementations of the sixteenth aspect.

According to a twenty-sixth aspect, an embodiment of this application provides a computer program product. The computer program product includes computer program code. When the computer program code is run on a computer, the computer is caused to perform any one of the sixteenth aspect or the possible implementations of the sixteenth aspect.

### BRIEF DESCRIPTION OF DRAWINGS

FIG. 1 is a diagram of an inverter circuit in a charging pile of an electric vehicle;
FIG. 2 is a diagram of dead time;
FIG. 3A and FIG. 3B are diagrams of a structure of a semiconductor device according to an embodiment of this application;
FIG. 4 is a diagram of another semiconductor device according to an embodiment of this application;
FIG. 5 is a diagram of another semiconductor device according to an embodiment of this application;
FIG. 6 is a diagram of another semiconductor device according to an embodiment of this application;
FIG. 7 is a diagram of another semiconductor device according to an embodiment of this application;
FIG. 8A and FIG. 8B are diagrams of electron injection directions and hole injection directions;
FIG. 9 is a diagram of a volt-ampere characteristic curve;
FIG. 10 is a block diagram of another semiconductor device according to an embodiment of this application;
FIG. 11 is a three-dimensional diagram of a semiconductor device according to an embodiment of this application;
FIG. 12 is a top view of a semiconductor device according to an embodiment of this application;
FIG. 13A to FIG. 13C are diagrams of arrangements of semiconductor regions;
FIG. 14 is a diagram of another semiconductor device according to an embodiment of this application;
FIG. 15 is a diagram of an electron injection direction and a hole injection direction;
FIG. 16 is a diagram of a volt-ampere characteristic curve;
FIG. 17 is a diagram of a control method according to an embodiment of this application;
FIG. 18 is a diagram of a control method according to an embodiment of this application; and
FIG. 19 is a volt-ampere characteristic curve.

### DESCRIPTION OF EMBODIMENTS

The following describes technical solutions of this application with reference to accompanying drawings.

First, some key terms in embodiments of this application are described.

### (1) N-type semiconductor

An N (Negative) type is also referred to as an electron type. An N-type semiconductor is a semiconductor in which electrical conduction is primarily carried by electrons. The N-type semiconductor is obtained by doping an intrinsic semiconductor with a donor impurity. For example, a small quantity of pentavalent elements (phosphorus, arsenic, or the like) is doped into pure silicon, and phosphorus forms covalent bonds with surrounding tetravalent silicon atoms, leaving an extra free electron. The N type may be further classified into an N+ type (electron-rich type) and an N- type (electron-deficient type), and an impurity concentration of an N+-type semiconductor is higher than an impurity concentration of an N--type semiconductor. It should be understood that the N+ type (electron-rich type) and the N- type (electron-deficient type) classifications are relative.

### (2) P-type semiconductor

A P (Positive) type is also referred to as a hole type. A P-type semiconductor is a semiconductor in which electrical conduction is primarily carried by holes. The P-type semiconductor is obtained by doping an intrinsic semiconductor with an acceptor impurity. For example, a small quantity of trivalent elements (boron, indium, or the like) is doped into pure silicon, and boron forms covalent bonds with surrounding tetravalent silicon atoms, leaving a hole due to absence of one electron. The P type may be further classified into a P+ type (hole-rich type) and a P- type (hole-deficient type), and an impurity concentration of a P+-type semiconductor is higher than an impurity concentration of a P--type semiconductor.

### (3) Insulated-gate bipolar transistor (insulated-gate bipolar transistor, IGBT)

The IGBT is a composite fully-controlled voltage-driven power semiconductor device formed by a bipolar junction transistor (bipolar junction transistor, BJT) and an insulated-gate field-effect transistor (metal-oxide-semiconductor field-effect transistor, MOSFET). The IGBT is suitable for application in a converter system with a direct current voltage of 600 V or above, for example, an alternating current motor, a frequency converter, a switching power supply, a lighting circuit, traction and transmission, and other fields.

### (4) Freewheeling diode (freewheeling diode, FWD) and fast recovery diode (fast recovery diode, FRD)

The FWD is a diode that freewheels when an IGBT is turned off in an inductive load switch circuit. The FRD is a diode having a fast reverse recovery speed.

### (5) Reverse conduction IGBT (reverse conduction IGBT, RC-IGBT)

The RC-IGBT is an IGBT structure integrating a diode, and the diode may freewheel when the IGBT is turned off.

### (6) Types and parameters of an IGBT

Development of the IGBT goes through different stages. A first-generation IGBT is a punch-through IGBT (punch-through IGBT, PT-IGBT), which uses a planar gate structure and a thick P-type substrate with a high doping concentration, and has an epitaxially grown N-type buffer region and an epitaxially grown drift region. During reverse blocking, an electric field is distributed in a trapezoidal shape. However, a withstand voltage level of a device is low, and a forward conduction voltage drop has a negative temperature characteristic, which is not conducive to parallel application.

A second-generation IGBT is a non-punch-through IGBT (non-punch through, NPT-IGBT), which features a trench gate structure and uses a lightly-doped N-type substrate as a drift layer, and a backside collector layer is formed through P-type impurity injection. During reverse blocking, the electric field is distributed in a triangle shape, and the withstand voltage level of the device is greatly improved. However, a thickness of the substrate also continuously increases, leading to both a high conduction voltage drop and a large switching loss.

A third-generation IGBT is a field stop IGBT (Field stop IGBT, FS-IGBT), which adds an N-type field stop layer based on a second-generation structure. During reverse blocking, the electric field is distributed in a trapezoidal shape, thereby reducing the thickness of the substrate while ensuring a sufficient withstand voltage of the device, so that both the conduction voltage drop and the switching loss are greatly reduced, and a compromise relationship between a conduction voltage drop Vcesat and a turn-off loss Eoff is improved.

A fourth-generation IGBT is a refined FS-IGBT, which further reduces the thickness of the substrate by reducing a cell size and optimizing distribution of a backside buffer region (for example, forming a deep buffer region through hydrogen injection), thereby obtaining higher power density and a better compromise relationship between the conduction voltage drop Vcesat and the turn-off loss Eoff.

The IGBT and the diode are important elements in an inverter circuit. The inverter circuit is a circuit that converts a direct current into an alternating current. The inverter circuit is widely used in fields such as electric vehicles and power systems. For example, the inverter circuit may be used in an electronic control system of the electric vehicle, and drives a motor of the vehicle through high-power direct current/alternating current inversion; the inverter circuit may be used in a low voltage system, a charging pile, and the like of the electric vehicle; or the inverter circuit may be used in a flexible alternating current transmission system (flexible AC transmission system, FACTS) in ultra-high voltage direct current transmission, a power conditioning system (power conditioning system, PCS) in wind power generation or photovoltaic power generation, an uninterruptible power supply (uninterruptible power supply, UPS), and the like.

In addition, household white goods, light-emitting diode (light-emitting diode, LED) lighting drivers, and the like also have a large demand for the IGBT.

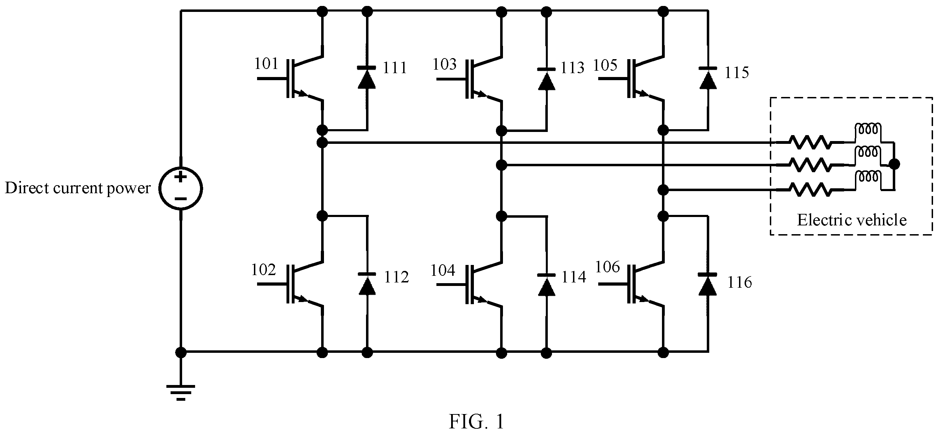

FIG. 1 is a diagram of the inverter circuit in the charging pile of the electric vehicle.

The inverter circuit shown in FIG. 1 includes six IGBTs (that is, an IGBT 101 to an IGBT 106) and six diodes (that is, a diode 111 to a diode 116).

As shown in FIG. 1, each IGBT has a reverse parallel diode. For example, a reverse parallel diode of the IGBT 101 is the diode 111, and a reverse parallel diode of the IGBT 102 is the diode 112. When the IGBT is turned off, the reverse parallel diode can quickly absorb a current generated by the IGBT and limit a change generated by a reverse voltage. Therefore, the reverse parallel diode can protect the IGBT from an overvoltage and a loss, to ensure normal operation and lifetime of the IGBT. In addition, the reverse parallel diode of the IGBT can also reduce turn-off time of the IGBT and reduce a sudden current change (which may be referred to as di/dt) during turn-off of the IGBT, thereby further reducing energy consumption and a failure risk of a device. The reverse diode may also be referred to as a freewheeling diode.

### (7) Dead time (dead time)

If upper IGBTs (for example, the IGBT 101, the IGBT 103, and the IGBT 105 in FIG. 1) and lower IGBTs (for example, the IGBT 102, the IGBT 104, and the IGBT 106 in FIG. 1) in an inverter circuit are simultaneously turned on, a short circuit may occur in a direct current power supply. Therefore, to prevent the upper IGBT and the lower IGBT in the inverter circuit from being simultaneously turned on, a period of time during which both the upper IGBT and the lower IGBT are turned off in an IGBT switching device is provided. This period referred to as the dead time. In other words, either the upper IGBT or the lower IGBT is turned off first, and then the other IGBT is turned on after the dead time ends.

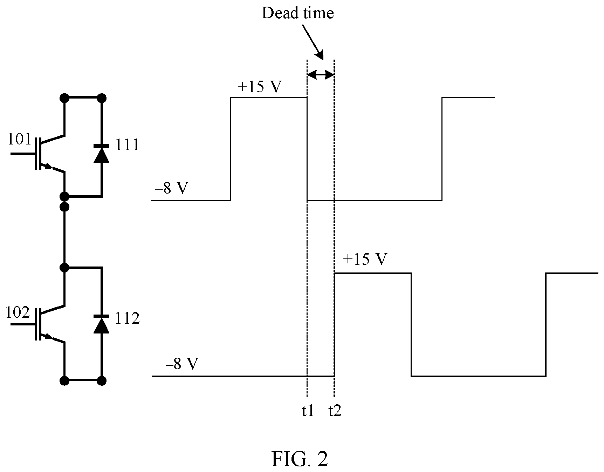

FIG. 2 is a diagram of the dead time.

As shown in FIG. 2, the IGBT 101 is turned off first. At a moment when the IGBT 101 just switches from being turned on to turned off (that is, a moment t1), the IGBT 102 is also in an off state. The IGBT 102 is turned on at an end of the dead time (that is, t2).

In some embodiments of this application, a first conductivity type may be an N type, and a second conductivity type may be a P type. In some other embodiments of this application, the first conductivity type may be a P type, and the second conductivity type may be an N type. If a channel type is the N type, the first conductivity type is the N type and the second conductivity type is the P type. If the channel type is the P type, the first conductivity type is the P type and the second conductivity type is the N type.

Embodiments of this application provide a semiconductor device. The semiconductor device includes a first semiconductor layer and a second semiconductor layer, where a conductivity type of the first semiconductor layer is a first conductivity type, the first semiconductor layer includes a plurality of pillars, the plurality of pillars are arranged in a first direction, the first direction is perpendicular to a thickness direction of the semiconductor device, and a conductivity type of the pillar is a second conductivity type; the second semiconductor layer is disposed above the first semiconductor layer, and a conductivity type of the second semiconductor layer is the second conductivity type; and the semiconductor device is divided, in the first direction, into an IGBT region for forming an insulated-gate bipolar transistor IGBT, a diode region for forming a diode, and a MOSFET region for forming a metal-oxide-semiconductor field-effect transistor MOSFET; the semiconductor device further includes a third semiconductor layer and a fourth semiconductor layer, where the third semiconductor layer is disposed below the first semiconductor layer and is located in the diode region and the MOSFET region, and a conductivity type of the third semiconductor layer is the first conductivity type; and the fourth semiconductor layer is disposed below the first semiconductor layer and is located in the IGBT region, and a conductivity type of the fourth semiconductor layer is the second conductivity type; and the semiconductor device further includes at least one first conductive material region, and the at least one first conductive material region is located in the diode region.

Optionally, the first conductivity type is different from the second conductivity type. For example, the first conductivity type may be an N type, and the second conductivity type may be a P type. For another example, the first conductivity type may be the P type, and the second conductivity type may be the N type. With reference to the foregoing technical solution, it is assumed that the first conductivity type is the N type, and the second conductivity type is the P type.

Optionally, the semiconductor device further includes at least one first semiconductor region, at least one second semiconductor region, at least one second conductive material region, and at least one third conductive material region, where the at least one third conductive material and the at least one first semiconductor region are located in the IGBT region; the at least one second conductive material region and the at least one second semiconductor region are located in the MOSFET region; and a conductivity type of the first semiconductor region and a conductivity type of the second semiconductor region are the first conductivity type.

With reference to the accompanying drawings, the following describes the semiconductor device provided in embodiments of this application.

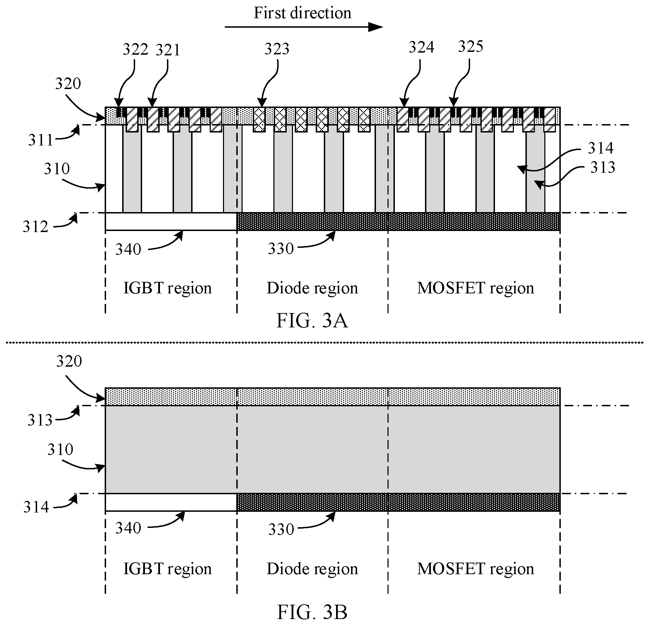

FIG. 3A and FIG. 3B are diagrams of a structure of a semiconductor device according to an embodiment of this application.

As shown in FIG. 3A, the semiconductor device may include a first semiconductor layer 310, a second semiconductor layer 320, a third semiconductor layer 330, and a fourth semiconductor layer 340.

The first semiconductor layer 310 includes a first surface 311 and a second surface 312. The first surface 311 is an upper surface of the first semiconductor layer 310, and the second surface 312 is a lower surface of the first semiconductor layer 310.

Refer to FIG. 3B. FIG. 3B is for more clearly showing the first semiconductor layer 310, the second semiconductor layer 320, the third semiconductor layer 330, the fourth semiconductor layer 340, the first surface 311, and the second surface 312.

The second semiconductor layer 320 is located above the first surface 311, and the third semiconductor layer 330 and the fourth semiconductor layer 340 are located below the second surface. In other words, the second semiconductor layer 320 is located above the first semiconductor layer 310, and the third semiconductor layer 330 and the fourth semiconductor layer 340 are located below the first semiconductor layer.

A conductivity type of the first semiconductor layer 310 is a first conductivity type. The first semiconductor layer 310 further includes a plurality of pillars 313. The pillars 313 are arranged in a first direction. The first direction is perpendicular to a thickness direction of the semiconductor device. A conductivity type of the pillar 313 is a second conductivity type. In other words, in addition to a region of the first conductivity type, the first semiconductor layer 310 further includes a region of the second conductivity type. The region of the second conductivity type is the pillar 313 shown in FIG. 3A. The region of the first conductivity type is a region 314 shown in FIG. 3A. It can be learned that the region of the first conductivity type is also the pillar arranged in the first direction. Therefore, the pillar 313 may also be referred to as a first pillar, and the region 314 may also be referred to as a second pillar. In other words, the first semiconductor layer 310 may include a plurality of first pillars that are arranged in the first direction and a plurality of second pillars that are arranged in a second direction, and the first pillar and the second pillar are alternately arranged. If the first conductivity type is an N type, and the second conductivity type is a P type, the first pillar may also be referred to as a P pillar, and the second pillar may also be referred to as an N pillar. The pillar 313 and the region 314 need to keep a charge balance.

Refer to FIG. 3A. The semiconductor device may be divided, in the first direction, into an IGBT region, a diode region, and a MOSFET region.

A second semiconductor layer in the IGBT region includes at least one conductive material region. A second semiconductor layer in the MOSFET region also includes at least one conductive material region. To facilitate distinguishing between the conductive material region located in the IGBT region and the conductive material region located in the MOSFET region, the conductive material region located in the IGBT region may be referred to as a third conductive material region, and the conductive material region located in the MOSFET region may be referred to as a second conductive material region. FIG. 3A shows five third conductive material regions 321 included in the IGBT region and eight second conductive material regions 324 included in the MOSFET region.

The second semiconductor layer in the IGBT region includes at least one semiconductor region. The second semiconductor layer in the MOSFET region also includes at least one semiconductor region. To facilitate distinguishing between the semiconductor region located in the IGBT region and the semiconductor region located in the MOSFET region, the semiconductor region located in the IGBT region may be referred to as a first semiconductor region, and the semiconductor region located in the MOSFET region may be referred to as a second semiconductor region. A conductivity type of the first semiconductor region and a conductivity type of the second semiconductor region are both the first conductivity type. FIG. 3A shows 10 first semiconductor regions 322 included in the IGBT region and 14 second semiconductor regions 325 included in the MOSFET region. As shown in FIG. 3A, the first semiconductor region 322 and the second semiconductor region 325 are located on a surface of the second semiconductor layer 320 facing away from the first semiconductor region. In some embodiments, the first semiconductor region 322 and the second semiconductor region 325 may be used as emitter regions.

Different from the IGBT region and the MOSFET region, a second semiconductor layer in the diode region includes at least one conductive material region. For ease of differentiation, the conductive material region located in the second semiconductor layer in the diode region may be referred to as a first conductive material region. As shown in FIG. 3A, the second semiconductor layer in the diode region includes six first conductive material regions 323.

A conductivity type of the second semiconductor layer 320 is the second conductivity type, a conductivity type of the third semiconductor layer 330 is the first conductivity type, and a conductivity type of the fourth semiconductor layer 340 is the second conductivity type.

In some embodiments, an impurity concentration of the third semiconductor layer 330 is different from an impurity concentration of the first semiconductor layer 310. For example, in some embodiments, the impurity concentration of the third semiconductor layer 330 is higher than the impurity concentration of the first semiconductor layer 310.

The third semiconductor layer 330 is located in the diode region and the MOSFET region. The fourth semiconductor layer 340 is located in the IGBT region. In other words, for the IGBT, the second semiconductor layer 320, the first semiconductor layer 310, and the fourth semiconductor layer 340 are sequentially arranged from top to bottom. For the MOSFET region and the diode region, the second semiconductor layer 320, the first semiconductor layer 310, and the fourth semiconductor layer 340 are sequentially arranged from top to bottom.

The third conductive material region, the second conductive material region, and the first conductive material region include conductive materials. For ease of description, the conductive material in the first conductive material region may be referred to as a first conductive material, the conductive material in the second conductive material region may be referred to as a second conductive material, and the conductive material in the third conductive material region may be referred to as a third conductive material. Although names of conductive materials in different conductive material regions are not completely the same, this does not mean that different conductive materials are used in the different conductive material regions. In other words, the conductive materials in the different conductive material regions may be the same or different. The conductive material is not limited in embodiments of this application. For example, the conductive material may be polysilicon, polysilicon deposited with metal or metal silicide, metal, or the like.

The conductive material region may use a planar structure (which may also be referred to as a planar gate), or may use a trench structure (which may also be referred to as a trench gate). However, to avoid unnecessary repetition, in embodiments of this application, the semiconductor device provided in this application is described by using the trench structure as an example. As shown in FIG. 3A and FIG. 3B, the third conductive material region 321 includes a third trench, the third trench is filled with the third conductive material, the third trench penetrates the second semiconductor layer and is in contact with the first semiconductor layer, and/or the third trench is in contact with the pillar 313 in the first semiconductor layer. Similarly, the second conductive material region 324 includes a second trench, the second trench is filled with the second conductive material, the second trench penetrates the second semiconductor layer and is in contact with the first semiconductor layer, and/or the second trench is in contact with the pillar 313 in the first semiconductor layer. The first conductive material region 323 includes a first trench, the first trench is filled with the first conductive material, the first trench penetrates the second semiconductor layer and is in contact with the first semiconductor layer, and/or the first trench is in contact with the pillar 313 in the first semiconductor layer.

In some embodiments, a metal layer may be further disposed below the fourth semiconductor layer and the third semiconductor layer as a collector electrode.

In some embodiments, conductive material regions (that is, the first conductive material region, the second conductive material region, and the third conductive material region) located above the semiconductor device may be classified into three types. A first-type conductive material region is in contact with only the pillar 313; a second-type conductive material region is in contact with only the region (that is, the region 314) of the first conductivity type in the first semiconductor layer; and a third-type conductive material region is in contact with both the pillar 313 and the region 314. For example, in FIG. 3A and FIG. 3B, a 1^{st} conductive material region from the left is the second-type conductive material region, a 2^{nd} conductive material region from the left is the first-type conductive material region, and a third electrode from the left is the third-type conductive material region. The contact between the conductive material region and the pillar 313 and/or the region 314 referred to herein means that the trench of the conductive material region extends to the first semiconductor layer 310 and is in contact with the pillar 313 and/or the region 314 located in the first semiconductor layer.

In some other embodiments, the conductive material region located above the semiconductor device may alternatively not be in contact with the first semiconductor layer. In other words, the trench of the conductive material region may not extend to the first semiconductor layer 310.

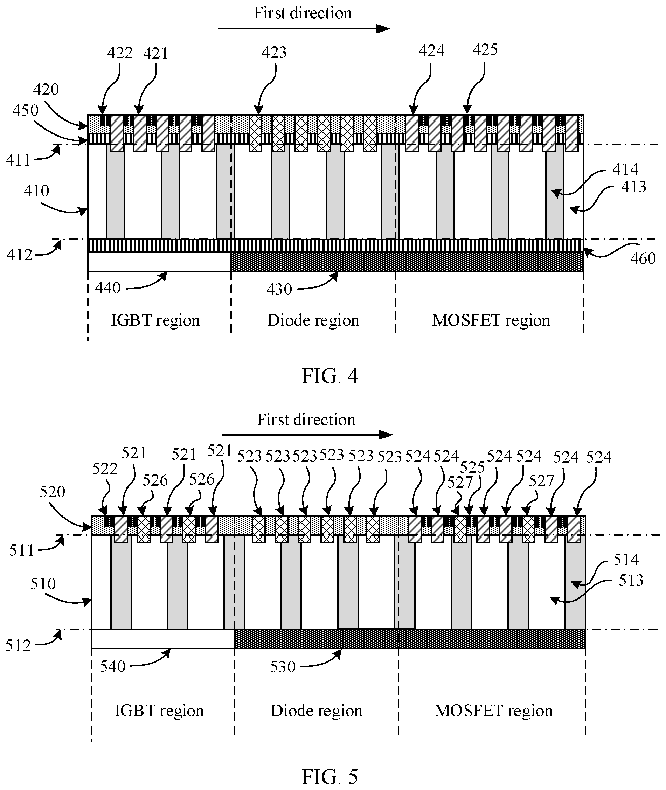

FIG. 4 is a diagram of another semiconductor device according to an embodiment of this application.

The semiconductor device shown in FIG. 4 includes a first semiconductor layer 410, a second semiconductor layer 420, a third semiconductor layer 430, and a fourth semiconductor layer 440. The semiconductor device shown in FIG. 4 further includes a third conductive material region 421, a second conductive material region 424, a first conductive material region 423, a first semiconductor region 422, and a second semiconductor region 424.

Similar to a first semiconductor layer 310 in the semiconductor device shown in FIG. 3A and FIG. 3B, the first semiconductor layer 410 in the semiconductor device shown in FIG. 4 also includes a plurality of pillars 413 (which may also be referred to as first pillars) arranged in a first direction and a region 414 (which may also be referred to as a second pillar) whose conductivity type is a first conductivity type. A conductivity type of the pillar 413 is a second conductivity type.

Different from the semiconductor device shown in FIG. 3A and FIG. 3B, in the semiconductor device shown in FIG. 4, a fifth semiconductor layer 450 is added above a first surface 411, and a sixth semiconductor layer 460 is added below a second surface 412. In other words, the fifth semiconductor layer 450 is included between the first semiconductor layer 410 and the second semiconductor layer 420, and the sixth semiconductor layer 460 is further included between the first semiconductor layer 410 and the third semiconductor layer 430 and the fourth semiconductor layer 440. For an IGBT region, the second semiconductor layer 420, the fifth semiconductor layer 450, the first semiconductor layer 410, the sixth semiconductor layer 460, and the fourth semiconductor layer 440 are sequentially included from top to bottom. For a diode region and a MOSFET region, the second semiconductor layer 420, the fifth semiconductor layer 450, the first semiconductor layer 410, the sixth semiconductor layer 460, and the third semiconductor layer 430 are included from top to bottom.

A conductivity type of the fifth semiconductor layer 450 may be the same as a conductivity type of the first semiconductor layer 410. In other words, the conductivity type of the fifth semiconductor layer 450 may be the first conductivity type.

In some embodiments, an impurity concentration of the fifth semiconductor layer 450 is different from an impurity concentration of the first semiconductor layer 410. For example, in some embodiments, the impurity concentration of the fifth semiconductor layer 450 is higher than the impurity concentration of the first semiconductor layer 410.

In this embodiment of this application, that impurity concentrations of two semiconductor layers are the same may include that the impurity concentrations are completely the same, that is, Conc₁-Conc₂=0, where Conc₁ represents an impurity concentration of one semiconductor layer, and Conc₂ represents an impurity concentration of the other semiconductor layer. In this embodiment of this application, that the impurity concentrations of the two semiconductor layers are the same may also include that the impurity concentrations are approximately the same. In other words, a difference between the impurity concentrations of the two semiconductor layer is less than a preset value, that is, Conc₁-Conc₂<TH, where Conc₁ represents an impurity concentration of one semiconductor layer, Conc₂ represents an impurity concentration of the other semiconductor layer, and TH represents the preset value. Correspondingly, if the difference between the impurity concentrations of the two semiconductor layers is greater than or equal to the preset value, it may be considered that the impurity concentrations of the two semiconductor layers are different.

A conductivity type of the sixth semiconductor layer 460 may also be the same as the conductivity type of the first semiconductor layer 410. In other words, the conductivity type of the sixth semiconductor layer 460 may be the first conductivity type.

In some embodiments, an impurity concentration of the sixth semiconductor layer 460 is different from the impurity concentration of the first semiconductor layer 410. For example, in some embodiments, the impurity concentration of the sixth semiconductor layer 460 is higher than the impurity concentration of the first semiconductor layer 410.

In some other embodiments, the impurity concentration of the sixth semiconductor layer 460 is the same as the impurity concentration of the first semiconductor layer 410. This structure may also be referred to as a semi-super junction structure.

A conductivity type of the third semiconductor layer 430 is the first conductivity type. In other words, the conductivity type of the third semiconductor layer 430 is the same as the conductivity type of the sixth semiconductor layer 460. Similarly, in some embodiments, an impurity concentration of the third semiconductor layer 430 may be higher than the impurity concentration of the sixth semiconductor layer 460.

Similar to the semiconductor device shown in FIG. 3A and FIG. 3B, a second semiconductor layer in the IGBT region in the semiconductor device shown in FIG. 4 also includes the third conductive material region 421 and the first semiconductor region 422. A second semiconductor layer in the diode region in the semiconductor device shown in FIG. 4 includes the first conductive material region 423. A second semiconductor layer in the MOSFET region in the semiconductor device shown in FIG. 4 includes the second conductive material region 424 and the second semiconductor region 425. A difference from the semiconductor device shown in FIG. 3A and FIG. 3B lies in that the first conductive material region, the second conductive material region, and the third conductive material region in the semiconductor device shown in FIG. 4 penetrate the second semiconductor layer 420 and the fifth semiconductor layer 450 and are in contact with the first semiconductor layer 410 and/or the pillar 413. For other features of the third conductive material region 421, the second conductive material region 424, the first semiconductor region 422, the second semiconductor region 425, and the first conductive material region 423, refer to descriptions in the embodiment shown in FIG. 3A and FIG. 3B. For brevity, details are not described herein again. Similarly, a metal layer may be further disposed below the fourth semiconductor layer 440 and the third semiconductor layer 430 as a collector electrode (not shown in the figure).

In some scenarios, the fifth semiconductor layer 450 may be referred to as a carrier storage (carrier storage, CS) layer. The sixth semiconductor layer 460 may be referred to as a buffer layer. The semiconductor device shown in FIG. 4 includes both the CS layer and the buffer layer. In some embodiments, only the CS layer may be disposed above the first surface of the first semiconductor layer in the semiconductor device. In other words, semiconductor layers in the semiconductor device may include only the first semiconductor layer 410, the second semiconductor layer 420, the third semiconductor layer 430, the fourth semiconductor layer 440, and the fifth semiconductor layer 450 shown in FIG. 4. In some other embodiments, only the buffer layer may be disposed below the second surface of the first semiconductor layer in the semiconductor device. In other words, the semiconductor layers in the semiconductor device may include only the first semiconductor layer 410, the second semiconductor layer 420, the third semiconductor layer 430, the fourth semiconductor layer 440, and the sixth semiconductor layer 460 shown in FIG. 4.

Conductive materials in the first conductive material region, the second conductive material region, and the third conductive material region in the semiconductor device each shown in FIG. 3A and FIG. 3B and FIG. 4 may be at a same potential as a gate or an emitter. If the conductive material region is at a same potential as the gate, the conductive material region may be referred to as a gate electrode. If the conductive material region is at a same potential as the emitter, the conductive material region may be referred to as an emitter electrode.

For example, in some embodiments, the conductive materials in the third conductive material region and the second conductive material region may be at the same potential as the gate. In this case, the third conductive material region may also be referred to as a first gate electrode, and the second conductive material region may also be referred to as a second gate electrode. For another example, in some embodiments, the first conductive material region is at the same potential as the emitter. In this case, the third conductive region may be referred to as an emitter electrode.

For another example, in some other embodiments, a part of third conductive material regions in a plurality of third conductive material regions are at the same potential as the gate, and the other part of third conductive material regions are at the same potential as the emitter.

For another example, in some other embodiments, a part of second conductive material regions in a plurality of second conductive material regions are at the same potential as the gate, and the other part of conductive material regions are at the same potential as the emitter.

FIG. 5 is a diagram of another semiconductor device according to an embodiment of this application. The semiconductor device shown in FIG. 5 includes a first semiconductor layer 510, a second semiconductor layer 520, a third semiconductor layer 530, and a fourth semiconductor layer 540. The first semiconductor layer 530 includes a pillar 513 and a region 514 whose conductivity type is a first conductivity type. The second semiconductor layer 520 includes a third conductive material region 521, a second conductive material region 524, a first semiconductor region 522, and a second semiconductor region 525. In addition, the second semiconductor layer 520 further includes a first conductive material region 523, a fourth conductive material region 526, and a fifth conductive material region 527. Similarly, a metal layer may be disposed below the fourth semiconductor layer 540 and the third semiconductor layer 530 as a collector electrode (not shown in the figure).

In some embodiments, the third conductive material region 521 and the second conductive material region 522 are at a same potential as a gate, and the first conductive material region, the fourth conductive material region, and the fifth conductive material region are at a same potential as an emitter. In this case, the third conductive material region 521 and the second conductive material region 522 may also be respectively referred to as a first gate electrode and a second gate electrode, and the first conductive material region 523, the fourth conductive material region 526, and the fifth conductive material region 527 may be respectively referred to as a first emitter electrode, a second emitter electrode, and a third emitter electrode. For ease of description, in this case, an IGBT region in the semiconductor device shown in FIG. 5 includes a plurality of gate electrodes (first gate electrodes) and a plurality of emitter electrodes (second emitter electrodes). All electrodes included in a diode region are emitter electrodes (first emitter electrodes). A MOSFET region includes a plurality of gate electrodes (second gate electrodes) and a plurality of emitter electrodes (third emitter electrodes).

A structure of the semiconductor device shown in FIG. 3A and FIG. 3B is the same as a structure of the semiconductor device shown in FIG. 5. A conductivity type of each component in the semiconductor device shown in FIG. 5 is the same as a conductivity type of a corresponding component in the semiconductor device shown in FIG. 3A and FIG. 3B. For example, the conductivity type of the region 513 is the first conductivity type, and a conductivity type of the pillar 514 is a second conductivity type. In addition, in some embodiments, a CS layer may be disposed above a first surface 511, and/or a buffer layer may be disposed below a second surface 512.

In the first direction, the IGBT region, the diode region, and the MOSFET region are sequentially arranged in the semiconductor device each shown in FIG. 3A and FIG. 3B to FIG. 5. For ease of description, this arrangement manner is referred to as a first arrangement manner or a boundary arrangement in the following descriptions.

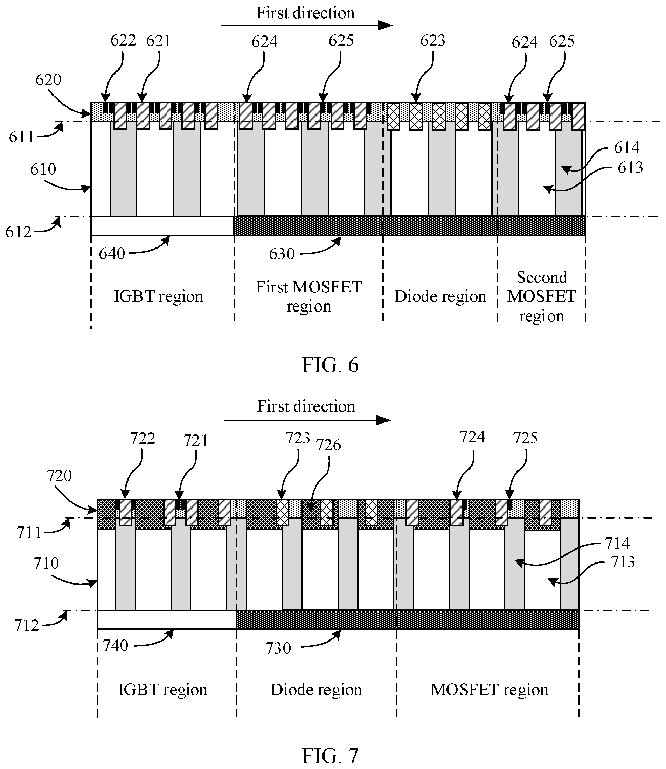

FIG. 6 is a diagram of another semiconductor device according to an embodiment of this application. In a first direction, an IGBT region, a first MOSFET region, a diode region, and a second MOSFET region are sequentially arranged in the semiconductor device shown in FIG. 6. For ease of description, this arrangement manner is referred to as a second arrangement manner or an internal arrangement in the following descriptions.

The semiconductor device shown in FIG. 6 includes a first semiconductor layer 610, a second semiconductor layer 620, a third semiconductor layer 630, and a fourth semiconductor layer 640, where the second semiconductor layer 620 is located above a first surface 611 of the first semiconductor layer 610, and the third semiconductor layer 630 and the fourth semiconductor layer 640 are located below a second surface 612 of the first semiconductor layer 610.

A conductivity type of the first semiconductor layer 610 is a first conductivity type. The first semiconductor layer 610 further includes a plurality of pillars 613. The pillars 613 are arranged in the first direction. A conductivity type of the pillar 613 is a second conductivity type. In other words, in addition to a region of the first conductivity type, the first semiconductor layer 610 further includes a region of the second conductivity type. The region of the second conductivity type is the pillar 613, and the region of the first conductivity type is a region 614. The pillar 613 may also be referred to as a first pillar, and the region 614 may also be referred to as a second pillar. In other words, the first semiconductor layer 610 includes a plurality of first pillars and a plurality of second pillars that are arranged in the first direction, a conductivity type of the first pillar is the second conductivity type, and a conductivity type of the second pillar is the first conductivity type. The first pillar and the second pillar are alternately arranged.

A second semiconductor layer in the IGBT region includes a plurality of third conductive material regions 621 and a plurality of first semiconductor regions 622.

A second semiconductor layer in the diode region includes a plurality of first conductive material regions 623.

It can be observed from comparison between the first MOSFET region and the second MOSFET region that a structure of the first MOSFET region and components included in the first MOSFET region are the same as a structure of the second MOSFET region and components included in the second MOSFET region. For example, the second semiconductor layer 620, the first semiconductor layer 610, and the third semiconductor layer 630 are sequentially arranged in the first MOSFET region and the second MOSFET region from top to bottom. Both the first MOSFET region and the second MOSFET region include a plurality of second semiconductor regions 625 and a plurality of second conductive material regions 624. It can be learned that in FIG. 6, a quantity of second conductive material regions 624 included in the first MOSFET region is greater than a quantity of second conductive material regions 624 included in the second MOSFET region. However, in some other embodiments, the quantity of second conductive material regions included in the first MOSFET region may alternatively be equal to or less than the quantity of second conductive material regions included in the second MOSFET region. Similarly, in FIG. 6, a quantity of second semiconductor regions 625 included in the first MOSFET region is greater than a quantity of second semiconductor regions 625 included in the second MOSFET region. However, in some other embodiments, the quantity of second semiconductor regions included in the first MOSFET region may alternatively be equal to or less than the quantity of second semiconductor regions included in the second MOSFET region. Similar to FIG. 3A and FIG. 3B, the third conductive material region and the second conductive material region herein are merely used for distinguishing between the conductive material region located in the IGBT region and the conductive material region located in the MOSFET region. Similarly, the first semiconductor region and the second semiconductor region are also used for distinguishing between the semiconductor region located in the IGBT region and the semiconductor region located in the MOSFET region.

It can be learned from comparison with FIG. 3A and FIG. 3B that the semiconductor device shown in FIG. 6 is equivalent to that the MOSFET region shown in FIG. 3A and FIG. 3B is divided by the diode region to obtain two MOSFET regions.

A conductivity type of each component in the semiconductor device shown in FIG. 6 is the same as a conductivity type of a corresponding component in the semiconductor device shown in FIG. 3A and FIG. 3B. For brevity, details are not described herein again.

Similarly, in some embodiments, in the semiconductor device shown in FIG. 6, a CS layer may also be disposed above the first surface 611 and/or a buffer layer may be inserted below the second surface 612.

In the first arrangement manner, the conductive material regions of the second semiconductor layer in the IGBT region may all be gate electrodes (that is, at a same potential as the gate), or may include a part of gate electrodes and a part of emitter electrodes (that is, at a same potential as the emitter). Similarly, in the second arrangement manner, the conductive material regions of the second semiconductor layer in the IGBT region may all be gate electrodes, or may include a part of gate electrodes and a part of emitter electrodes. Similarly, in the first arrangement manner, the conductive material regions of the second semiconductor layer in the MOSFET region may all be gate electrodes, or may include a part of gate electrodes and a part of emitter electrodes. In the second arrangement manner, conductive material regions of a second semiconductor layer in a first IGBT region may all be gate electrodes, or may include a part of gate electrodes and a part of emitter electrodes. Conductive material regions of a second semiconductor layer in a second IGBT region may all be gate electrodes, or may include a part of gate electrodes and a part of emitter electrodes.

FIG. 7 is a diagram of another semiconductor device according to an embodiment of this application. The semiconductor device shown in FIG. 7 includes a first semiconductor layer 710, a second semiconductor layer 720, a third semiconductor layer 730, and a fourth semiconductor layer 740.

A structure of the first semiconductor layer 710 is the same as a structure of the first semiconductor layer each in FIG. 3A and FIG. 3B to FIG. 6. The first semiconductor layer 710 includes a plurality of pillars 713 and a region 714 that are arranged in a first direction.

Similarly, the second semiconductor layer 720 is located above a first surface 711 of the first semiconductor layer 710, and the third semiconductor layer 730 and the fourth semiconductor layer 740 are located below a second surface 712 of the first semiconductor layer 710.

In the first direction, the semiconductor device sequentially includes an IGBT region, a diode region, and a MOSFET region. A second semiconductor layer 720 in the IGBT region includes a third conductive material region 722 and a first semiconductor region 721. A second semiconductor layer 720 in the diode region includes a first conductive material region 323. A second semiconductor layer 720 in the MOSFET region includes a second conductive material region 724 and a second semiconductor region 725. Similarly, the third conductive material region and the second conductive material region herein are merely used for distinguishing between the conductive material region located in the IGBT region and the conductive material region located in the MOSFET region. Similarly, the first semiconductor region and the second semiconductor region are also used for distinguishing between the semiconductor region located in the IGBT region and the semiconductor region located in the MOSFET region.

A conductivity type of each component in the semiconductor device shown in FIG. 7 is the same as a conductivity type of a corresponding component in the semiconductor device shown in FIG. 3A and FIG. 3B. For brevity, details are not described herein again.

Compared with the semiconductor device shown in FIG. 3A and FIG. 3B, the semiconductor device shown in FIG. 7 further includes a plurality of floating regions 726. The floating regions in the semiconductor device shown in FIG. 7 are in one-to-one correspondence with the pillars 713, and each floating region penetrates the second semiconductor layer and is in contact with the corresponding pillar. A conductivity type of the floating region is the same as a conductivity type of the corresponding pillar. In other words, the conductivity type of the floating region is a second conductivity type.

Optionally, in some other embodiments, only a part of pillars in the semiconductor device may have corresponding floating regions. Similar to the semiconductor device shown in FIG. 7, the floating regions corresponding to the pillars also penetrate the second semiconductor layer and are in contact with the corresponding pillars.

Similarly, in the semiconductor device shown in FIG. 7, a CS layer may be added above the first surface 711 of the first semiconductor layer 710, and/or a buffer layer may be added below the second surface 712. In addition, conductive material regions of the second semiconductor layer in the IGBT region and the second semiconductor layer in the MOSFET region in the semiconductor device shown in FIG. 7 are all at a same potential as a gate. In some other embodiments, a part of conductive material regions of the second semiconductor layer in the IGBT region and the second semiconductor layer in the MOSFET region in the semiconductor device shown in FIG. 7 may also be at a same potential as an emitter. In other words, similar to the foregoing embodiment, the conductive material regions of the second semiconductor layer in the IGBT region and the second semiconductor layer in the MOSFET region shown in FIG. 7 may include the conductive material regions that are at the same potential as the emitter and the conductive material regions that are at the same potential as the gate.

Similarly, in the semiconductor device shown in FIG. 7, a metal layer may be further disposed below the third semiconductor layer 730 and the fourth semiconductor layer 740 as a collector electrode.

It can be learned that the semiconductor device shown in FIG. 7 is a semiconductor device in a first arrangement manner. The semiconductor device in the second arrangement manner shown in FIG. 6 may also include the floating region. For example, in some embodiments, each pillar 613 in the semiconductor device shown in FIG. 6 has a corresponding floating region. For another example, in some other embodiments, a part of pillars 613 in the semiconductor device shown in FIG. 6 have corresponding floating regions. The floating region penetrates the second semiconductor layer and is in contact with the corresponding pillar.

As described above, in some embodiments, the semiconductor device each shown in FIG. 5 to FIG. 7 may add the buffer layer above the first surface of the first semiconductor layer. In this case, the conductive material region needs to penetrate the second semiconductor layer and the buffer layer. Correspondingly, if the semiconductor device further includes the floating region, the floating region also needs to penetrate the second semiconductor layer and the buffer layer.

In some embodiments, if the conductivity type of the floating region is a P type, the floating region may also be referred to as a floating P-type region.

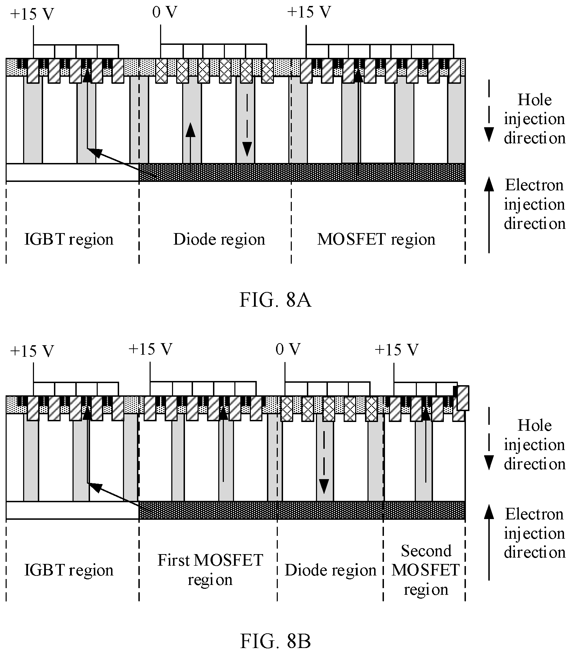

FIG. 8A shows an electron injection direction (a solid arrow) and a hole injection direction (dashed arrow) of the semiconductor device in the first arrangement manner (boundary arrangement).

FIG. 8B shows an electron injection direction (a solid arrow) and a hole injection direction (dashed arrow) of the semiconductor device in the second arrangement manner (internal arrangement).

It is assumed that the first conductivity type is an N type, and the second conductivity type is a P type. In this case, as shown in FIG. 8A and FIG. 8B, when a forward voltage is applied to the diode region, an N-type cathode region of a diode is for injecting electrons from a cathode direction. If a conductive material region located the diode is at a same potential as the emitter, formation of a channel can be avoided. When the forward voltage is applied to the gate, a hole may be injected from the second semiconductor layer into an N-type region of the first semiconductor layer. This can reduce a voltage drop in a synchronous rectification (synchronous rectification) mode, thereby improving synchronous rectification performance of the semiconductor device.

In some embodiments, semiconductor regions that may be used as emitter regions, such as the first semiconductor region and the second semiconductor region, may not be disposed in the second semiconductor layer in the diode region. This can avoid an electron current flowing to the emitter.

In addition, an area proportion of the diode region to a total region (that is, the diode region+the MOSFET region+the IGBT region) affects a current conduction characteristic of the diode in a reverse bias condition and a current conduction characteristic of an IGBT and a MOSFET in a forward bias condition. A larger proportion of the diode region to the total region indicates a smaller conduction voltage drop under a high current during reverse conduction. The larger proportion of the diode region to the total region indicates a larger conduction voltage drop under a high current and a low current during forward conduction.

In the semiconductor device each in FIG. 3A and FIG. 3B to FIG. 8A and FIG. 8B, a diode formed in the diode region and a body diode in the MOSFET region may form an FWD.

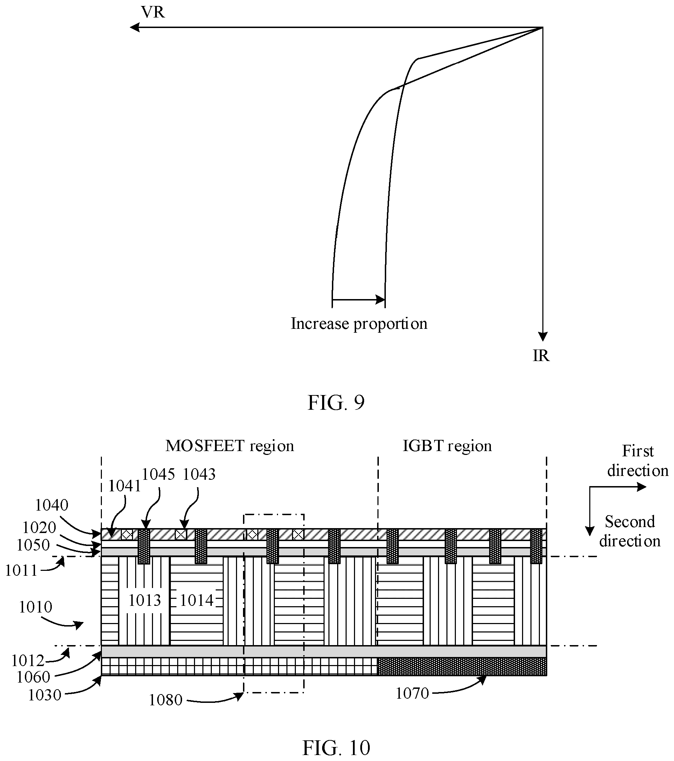

FIG. 9 shows a reverse current (reverse current, IR)-reverse voltage (reverse voltage, VR) characteristic curve of the semiconductor element according to the technical solution of this application.

As shown in FIG. 9, when the forward voltage is applied to the gate, a reverse conduction voltage significantly decreases because the hole is injected from the diode. In addition, with an increase of the proportion of the diode region to the total region, a trend of the reverse conduction voltage decreasing is more pronounced.

In some embodiments, it may be considered that FIG. 3A and FIG. 3B to FIG. 8A and FIG. 8B show a cell of the semiconductor device provided in embodiments of this application, where the IGBT region, the MOSFET region, and the diode region are three sub-cells of the cell. Similarly, the first MOSFET region and the second MOSFET region may also be considered as two sub-cells. The semiconductor device provided in embodiments of this application may include one or more cells. A quantity of cells included in the semiconductor device is not limited in embodiments of this application.

FIG. 10 is a block diagram of another semiconductor device according to an embodiment of this application. The semiconductor device includes an IGBT region, a diode region, and a MOSFET region in a first direction. The first direction, a second direction, and a third direction of the semiconductor device are perpendicular to each other, and the second direction is a thickness direction of the semiconductor device.

The MOSFET region in the semiconductor device includes a first semiconductor layer 1010, a second semiconductor layer 1020, a third semiconductor layer 1030, a fourth semiconductor layer 1040, a fifth semiconductor layer 1050, and a sixth semiconductor layer 1060.

A conductivity type of the first semiconductor layer 1010 is a first conductivity type. The first semiconductor layer includes a first surface 1011 and a second surface 1012 that are opposite to each other. The first semiconductor layer further includes a plurality of pillars 1013, the plurality of pillars are arranged in the first direction, and a conductivity type of the pillar is a second conductivity type. In addition to the pillar 1013, the first semiconductor layer 1010 further includes a region 1014 whose conductivity type is the first conductivity type. As shown in FIG. 10, the region 1014 may also be a pillar. Therefore, the pillar 1013 may also be referred to as a first pillar 1013, and the region 1014 may also be referred to as a second pillar 1014. If the first conductivity type is an N type, and the second conductivity type is a P type, the first pillar may also be referred to as a P pillar, and the second pillar may also be referred to as an N pillar.

A conductivity type of the second semiconductor layer 1020 is the second conductivity type. The second semiconductor layer 1020 is disposed above the first surface 1011 of the first semiconductor layer 1010. As shown in FIG. 10, the fifth semiconductor layer 1050 is further included between the second semiconductor layer 1020 and the first semiconductor layer 1010. A conductivity type of the fifth semiconductor layer 1050 is the first conductivity type.

A conductivity type of the third semiconductor layer 1030 is the first conductivity type. The third semiconductor layer 1030 is disposed below the second surface 1012 of the first semiconductor layer 1010. As shown in FIG. 10, the sixth semiconductor layer 1060 is further included between the third semiconductor layer 1030 and the first semiconductor layer 1010. A conductivity type of the sixth semiconductor layer 1060 is the first conductivity type.

In some embodiments, the fifth semiconductor layer 1050 and the sixth semiconductor layer 1060 may also be referred to as buffer layers. The semiconductor device shown in FIG. 10 includes two buffer layers (that is, the fifth semiconductor layer 1050 and the sixth semiconductor layer 1060). Some other semiconductor devices provided in embodiments of this application may include only one buffer layer. For example, in some embodiments, the semiconductor device may include only the fifth semiconductor layer 1050 or the sixth semiconductor layer 1060 shown in FIG. 10. Alternatively, some other semiconductor devices provided in embodiments of this application may not include the buffer layer. In other words, in some embodiments, the semiconductor device may not include the fifth semiconductor layer 1050 and the sixth semiconductor layer 1060 shown in FIG. 10.

The fourth semiconductor layer 1040 is disposed on a surface of the second semiconductor layer 1020 facing away from the first semiconductor layer. The fourth semiconductor layer 1040 includes a first semiconductor region 1041 and a second semiconductor region (not shown in FIG. 10) that are disposed in parallel on two sides of the fourth semiconductor layer, a plurality of conductive material regions 1045 that are disposed in parallel, and a plurality of third semiconductor regions 1043 that are disposed in parallel. In some embodiments, the conductive material region 1045 may be at a same potential as a gate. In this case, the conductive material region 1045 may also be referred to as a gate electrode.

The first semiconductor region 1041 and the second semiconductor region are parallel to the first direction. A conductivity type of the first semiconductor region 1041 and a conductivity type of the second semiconductor region are the first conductivity type.

The conductive material region 1045 is parallel to the third direction.

The third semiconductor region 1043 is parallel to the third direction. A conductivity type of the third semiconductor region 1043 is the second conductivity type.

The fourth semiconductor layer 1040 further includes a fourth semiconductor region (not shown in the figure). The fourth semiconductor region is located between the third semiconductor region 1043 and the conductive material region 1045. A conductivity type of the fourth semiconductor region is the second conductivity type.

The semiconductor device may be a semiconductor device of a planar gate structure, or may be a semiconductor device of a trench gate structure. For ease of description, the semiconductor device provided in this application is described by using a trench gate as an example in the following descriptions.

Conductivity types of the second pillar 1014 in the first semiconductor layer 1010, the fifth semiconductor layer 1050, the sixth semiconductor layer 1060, the third semiconductor layer 1030, the first semiconductor region 1041, and the second semiconductor region are all the first conductivity type. For ease of description, regions whose conductivity types are the first conductivity type may be referred to as first-type regions. Similarly, conductivity types of the first pillar 1013, the second semiconductor layer 1020, the third semiconductor region 1043, the fourth semiconductor region, and a seventh semiconductor layer 1070 in the IGBT region are all the second conductivity type. Similarly, for ease of description, regions whose conductivity types are the second conductivity type may be referred to as second-type regions.

In some embodiments, impurity concentrations of the first-type regions may be completely the same. In other words, impurity concentrations of any two semiconductor layers (semiconductor regions) in the second pillar 1014 in the first semiconductor layer 1010, the fifth semiconductor layer 1050, the sixth semiconductor layer 1060, the third semiconductor layer 1030, the first semiconductor region 1041, or the second semiconductor region are completely the same.

In some other embodiments, the impurity concentrations of the first-type regions are completely different. In other words, the impurity concentrations of any two semiconductor layers (semiconductor regions) in the second pillar 1014 in the first semiconductor layer 1010, the fifth semiconductor layer 1050, the sixth semiconductor layer 1060, the third semiconductor layer 1030, the first semiconductor region 1041, or the second semiconductor region are completely different.

In some other embodiments, the impurity concentrations of the first-type regions may not be completely the same. Herein, what is referred to as "not completely the same" includes: Impurity concentrations of some semiconductor layers and/or semiconductor regions are the same, but the impurity concentrations of the semiconductor layers and/or semiconductor regions are different from impurity concentrations of some other semiconductor regions and/or semiconductor layers. For example, in some embodiments, the impurity concentration of the first semiconductor region is the same as the impurity concentration of the second semiconductor region; the impurity concentration of the fifth semiconductor layer 1050 is the same as the impurity concentration of the sixth semiconductor layer 1060, but the impurity concentration of the sixth semiconductor layer 1060 is different from the impurity concentration of the second pillar 1014, and the impurity concentration of the sixth semiconductor layer 1060 is also different from the impurity concentration of the third semiconductor layer 1030.

Similarly, in some embodiments, impurity concentrations of the second-type regions may be completely the same. In other words, impurity concentrations of any two semiconductor layers (semiconductor regions) in the first pillar 1013, the second semiconductor layer 1020, the third semiconductor region 1043, the fourth semiconductor region, or the seventh semiconductor layer 1070 are completely the same.

In some other embodiments, the impurity concentrations of the second-type regions are completely different. In other words, the impurity concentrations of any two semiconductor layers (semiconductor regions) in the first pillar 1013, the second semiconductor layer 1020, the third semiconductor region 1043, the fourth semiconductor region, or the seventh semiconductor layer 1070 are completely different.

In some other embodiments, the impurity concentrations of the second-type regions may not be completely the same. Herein, what is referred to as "not completely the same" includes: Impurity concentrations of some semiconductor layers and/or semiconductor regions are the same, but the impurity concentrations of the semiconductor layers and/or semiconductor regions are different from impurity concentrations of some other semiconductor regions and/or semiconductor layers. For example, in some embodiments, the impurity concentration of the second semiconductor layer 1020 is the same as the impurity concentration of the fourth semiconductor region, but the impurity concentration of the second semiconductor layer 1020 is different from the impurity concentration of the third semiconductor layer 1043.

It may be understood that the semiconductor device provided in this embodiment of this application may be the semiconductor device of the trench gate structure shown in FIG. 10, or may be the semiconductor device of the planar gate structure.

The semiconductor device shown in FIG. 10 includes the MOSFET region and the IGBT region in the first direction. It may be understood that a cell of the semiconductor device shown in FIG. 10 is indicated. The semiconductor device may further include a plurality of cells shown in FIG. 10. In addition, the MOSFET region and the IGBT region in the semiconductor device alternately appear. Therefore, it may also be considered that the cell sequentially includes the IGBT region and the MOSFET region.

Optionally, in some embodiments, the cell of the semiconductor device may further include a region other than the MOSFET region and the IGBT region in FIG. 10. For example, in some embodiments, the semiconductor device may further include the diode region. For example, a MOSFET region in the semiconductor device each shown in FIG. 3A and FIG. 3B to FIG. 5 may also use a structure same as that of the MOSFET region shown in FIG. 10. For another example, at least one of a first MOSFET region or a second MOSFET region in the semiconductor device shown in FIG. 6 may also use a structure same as that of the MOSFET region shown in FIG. 10.

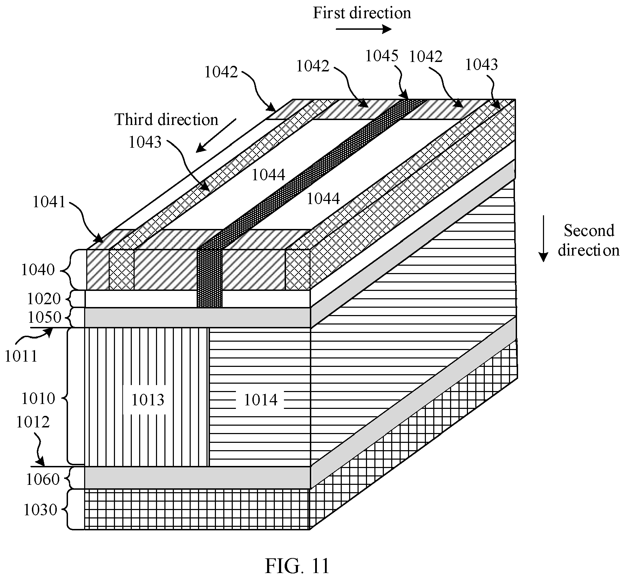

FIG. 11 is a three-dimensional diagram of a semiconductor device according to an embodiment of this application. The semiconductor device shown in FIG. 11 is a three-dimensional diagram of a region 1080 shown in FIG. 10.

The semiconductor device shown in FIG. 11 includes a first semiconductor layer 1010, a second semiconductor layer 1020, a third semiconductor layer 1030, a fourth semiconductor layer 1040, a fifth semiconductor layer 1060, and a sixth semiconductor layer 1060.

The first semiconductor layer 1010 includes a first surface 1011 and a second surface 1012 that are opposite to each other. The first semiconductor layer further includes a region 1014 (which may also be referred to as a second pillar 1014) whose conductivity type is a first conductivity type and a pillar 1013 (which may also be referred to as a first pillar 1013) whose conductivity type is a second conductivity type.

For related information of the second semiconductor layer 1020, the third semiconductor layer 1030, the fifth semiconductor layer 1050, and the sixth semiconductor layer 1060, refer to descriptions in the foregoing embodiment. For brevity, details are not described herein again.

The fourth semiconductor layer 1040 shown in FIG. 11 shows a fourth semiconductor region 1044 and a second semiconductor region 1042 that are not shown in FIG. 10. In addition, the fourth semiconductor layer 1040 further includes a first semiconductor region 1041, a third semiconductor region 1043, and a conductive material region 1045.

As shown in FIG. 11, the first semiconductor region 1041 and the second semiconductor region 1042 are disposed in parallel on two sides of the fourth semiconductor layer 1040. The first semiconductor region 1040 and the second semiconductor region 1042 are parallel to a first direction. The first direction is perpendicular to a second direction, and the second direction is a thickness direction of the semiconductor device. A third direction is also perpendicular to the first direction or the second direction. In other words, the first direction, the second direction, and the third direction are perpendicular to each other. In some embodiments, the first direction may also be referred to as an x direction, the second direction may also be referred to as a y direction, and the third direction may also be referred to as a z direction.

FIG. 11 shows two third semiconductor regions 1043. Herein, the two third semiconductor regions 1043 are disposed in parallel, and the third semiconductor region is parallel to the third direction.

As shown in FIG. 11, the fourth semiconductor region 1044 is located between the conductive material region 1045 and the third semiconductor region 1043.

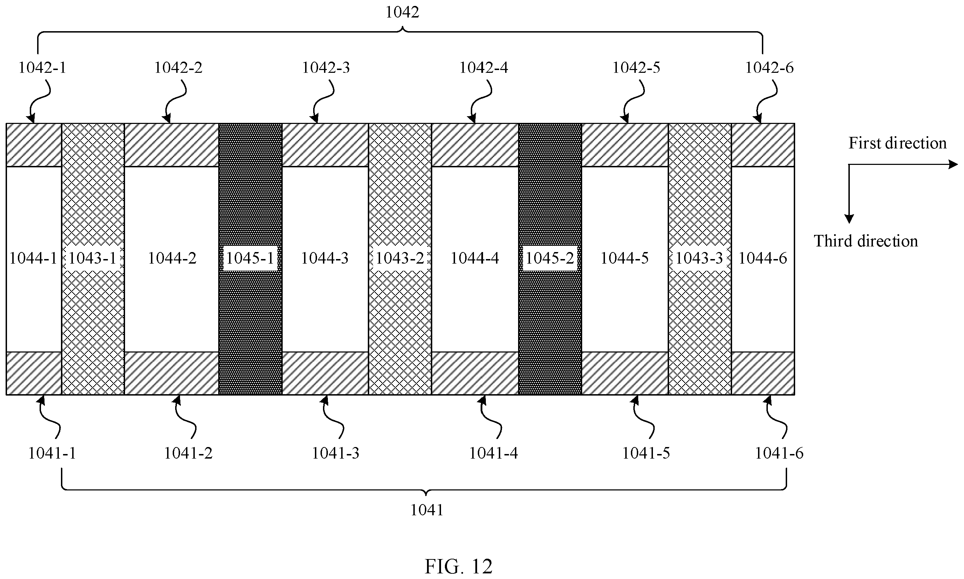

FIG. 11 shows only one conductive material region 1045. However, as described above, the conductive material region 1045 shown in FIG. 11 and another conductive material region are also disposed in the fourth semiconductor region 1040 in parallel to the third direction. FIG. 12 is a top view of the semiconductor device shown in FIG. 10. The top view shown in FIG. 12 shows conductive material regions 1045 disposed in parallel. FIG. 12 shows two conductive material regions 1045. For ease of description, the two conductive material regions are marked as 1045-1 and 1045-2 in FIG. 12. As shown in FIG. 12, the conductive material region 1045-1 is parallel to the conductive material region 1045-2, and the conductive material region 1045-1 is parallel to the third direction. In addition to the conductive material region, FIG. 12 further shows three third semiconductor regions. Similarly, for ease of description, the three third semiconductor regions shown in FIG. 12 are respectively denoted as 1043-1, 1043-2, and 1043-3. As shown in FIG. 12, the third semiconductor device 1043-1 is parallel to the third semiconductor region 1043-2, and the third semiconductor region 1043-2 is parallel to the third semiconductor region 1043-3. In addition, the three third semiconductor regions are parallel to the third direction.

The third semiconductor region and the conductive material region divide the first semiconductor region into a plurality of first sub-semiconductor regions. As shown in FIG. 12, the third semiconductor region and the conductive material region divide the first semiconductor region 1041 into six first sub-semiconductor regions, that is, a first sub-semiconductor region 1041-1 to a first sub-semiconductor region 1041-6. Similarly, the third semiconductor region and the conductive material region divide the second semiconductor region into a plurality of second sub-semiconductor regions. As shown in FIG. 12, the third semiconductor region and the conductive material region divide the second semiconductor region 1042 into six second sub-semiconductor regions, that is, a second sub-semiconductor region 1042-1 to a second sub-semiconductor region 1042-2.

FIG. 12 further shows six fourth semiconductor regions, that is, a fourth semiconductor region 1044-1 to a fourth semiconductor region 1044-6. As shown in FIG. 12, the fourth semiconductor region is located between the conductive material region and the third semiconductor region. For example, the fourth semiconductor region 1044-2 is located between the third semiconductor region 1043-1 and the conductive material region 1045-1. Further, the fourth semiconductor region 1044-2 is located in a region enclosed by the third semiconductor region 1043-1, the conductive material region 1045-2, the first sub-semiconductor region 1041-2, and the second sub-semiconductor region 1042-2. For another example, the fourth semiconductor region 1044-5 is located between the conductive material region 1045-2 and the third semiconductor region 1043-3. Further, the fourth semiconductor region 1044-5 is located in a region enclosed by the conductive material region 1045-2, the third semiconductor region 1043-3, the first sub-semiconductor region 1041-5, and the second sub-semiconductor region 1042-5.

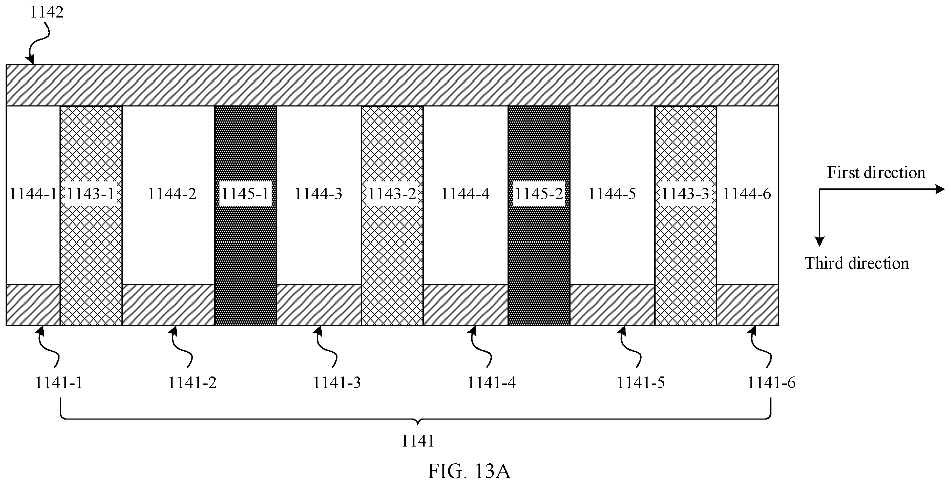

FIG. 13A to FIG. 13C show other arrangement manners of semiconductor regions included in the fourth semiconductor layer.

As shown in FIG. 13A, a first semiconductor region 1141 and a second semiconductor region 1142 are disposed in parallel on the two sides of the fourth semiconductor layer, and the first semiconductor region 1141 and the second semiconductor region 1142 are parallel to the third direction. The first semiconductor region 1141 is divided into a plurality of first sub-semiconductor regions, that is, a first sub-semiconductor region 1141-1 to a first sub-semiconductor region 1141-6, by third semiconductor regions 1143-1 to 1143-3, a conductive material region 1145-1, and a conductive material region 1145-2. Each of fourth semiconductor regions 1144-1 to 1144-6 corresponds to one third semiconductor region and one conductive material region, and each conductive material region is between the corresponding third semiconductor region and the corresponding conductive material region. The plurality of third semiconductor regions are disposed in parallel and parallel to the third direction. The plurality of conductive material regions are disposed in parallel and parallel to the third direction.

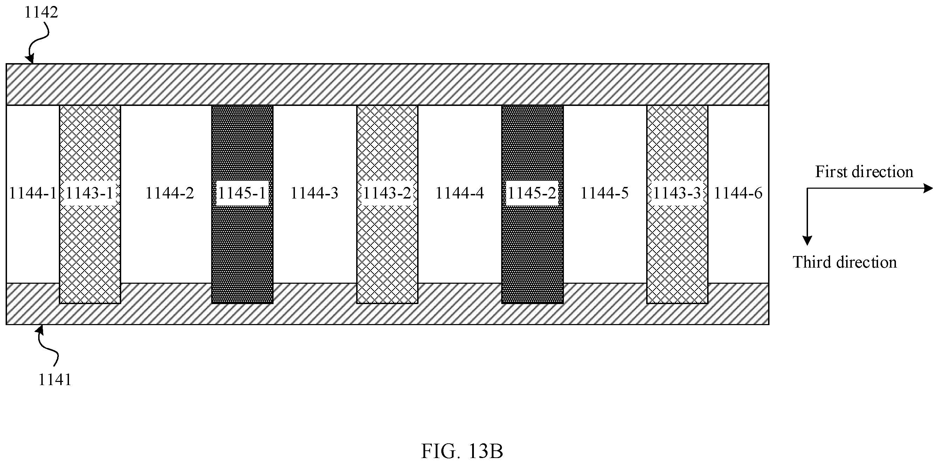

As shown in FIG. 13B, a first semiconductor region 1141 and a second semiconductor region 1142 are disposed in parallel on the two sides of the fourth semiconductor layer, and the first semiconductor region 1141 and the second semiconductor region 1142 are parallel to the third direction. The first semiconductor region 1141 includes a plurality of recesses, each of the plurality of recesses corresponds to one third semiconductor region or one conductive material region, and each recess is provided with a part of the corresponding third semiconductor region or a part of the corresponding conductive material region. For example, a first recess from left to right corresponds to a third semiconductor region 1143-1, and a part of the third semiconductor region 1143-1 is disposed in the recess; a second recess from left to right corresponds to a conductive material region 1145-1, and a part of the conductive material region 1145-1 is disposed in the recess. FIG. 13B further shows third semiconductor regions 1143-1 to 1143-3. The third semiconductor regions are disposed in parallel and are parallel to the third direction. The conductive material region 1145-1 and the conductive material region 1145-2 are disposed in parallel and are parallel to the third direction. Each of fourth semiconductor regions 1141-1 to 1144-6 corresponds to one third semiconductor region and one conductive material region, and each conductive material region is between the corresponding third semiconductor region and the corresponding conductive material region.

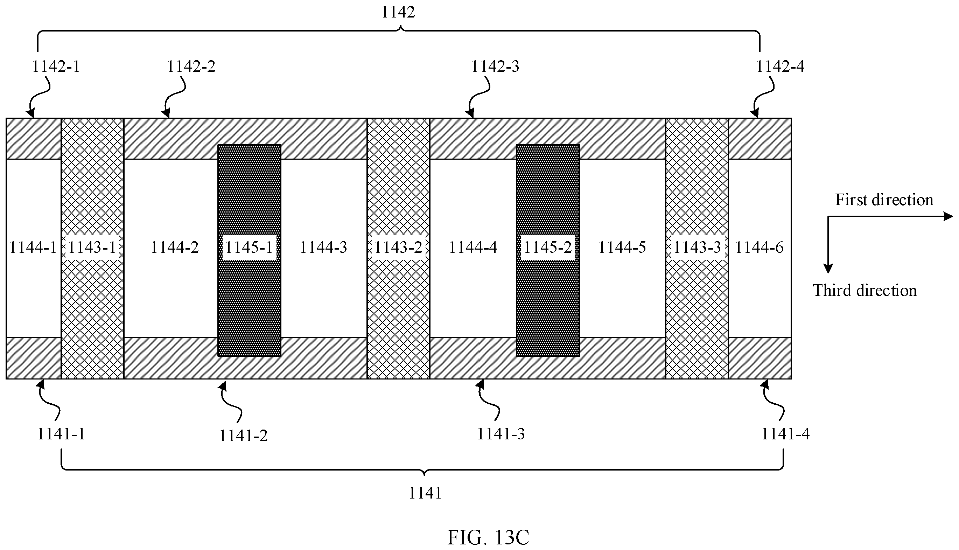

As shown in FIG. 13C, a first semiconductor region 1141 and a second semiconductor region 1142 are disposed in parallel on the two sides of the fourth semiconductor layer, and the first semiconductor region 1141 and the second semiconductor region 1142 are parallel to the third direction. The first semiconductor region 1141 is divided into a plurality of first sub-semiconductor regions, that is, a first sub-semiconductor region 1141-1 to a first sub-semiconductor region 1141-4, by third semiconductor regions 1143-1 to 1143-3. The first semiconductor region 1141 further includes two recesses, and the two recesses herein are respectively for accommodating a part of a conductive material region 1145-1 and a part of a conductive material region 1145-2. Similarly, the second semiconductor region 1142 is also divided into a plurality of second sub-semiconductor regions, that is, a second sub-semiconductor region 1142-1 to a second sub-semiconductor region 1142-2, by the third semiconductor regions 1143-1 to 1143-3. The second semiconductor region 1142 also includes two recesses, and the two recesses herein are respectively for accommodating a part of the conductive material region 1145-1 and a part of the conductive material region 1145-2. FIG. 13C further shows the third semiconductor regions 1143-1 to 1143-3. The third semiconductor regions are disposed in parallel and are parallel to the third direction. The conductive material region 1145-1 and the conductive material region 1145-2 are disposed in parallel and are parallel to the third direction. Each of fourth semiconductor regions 1141-1 to 1144-6 corresponds to one third semiconductor region and one conductive material region, and each conductive material region is between the corresponding third semiconductor region and the corresponding conductive material region.

Arrangement manners of the semiconductor regions and the conductive material regions shown in FIG. 13A, FIG. 13B, and FIG. 13C are merely some possible arrangement manners provided in this embodiment of this application. A person skilled in the art may further obtain other arrangement manners based on the content disclosed in this application, and these arrangement manners shall fall within the protection scope of this application.

As described above, the fifth semiconductor layer 1050 each shown in FIG. 10 and FIG. 11 is a CS layer, and the sixth semiconductor layer 1060 is a buffer layer. In some embodiments, the semiconductor device may include only one of the CS layer and the buffer layer (where for example, there is only the fifth semiconductor layer 1050 or the sixth semiconductor layer 1060). In some other embodiments, the semiconductor device may alternatively not include the CS layer and the buffer layer.

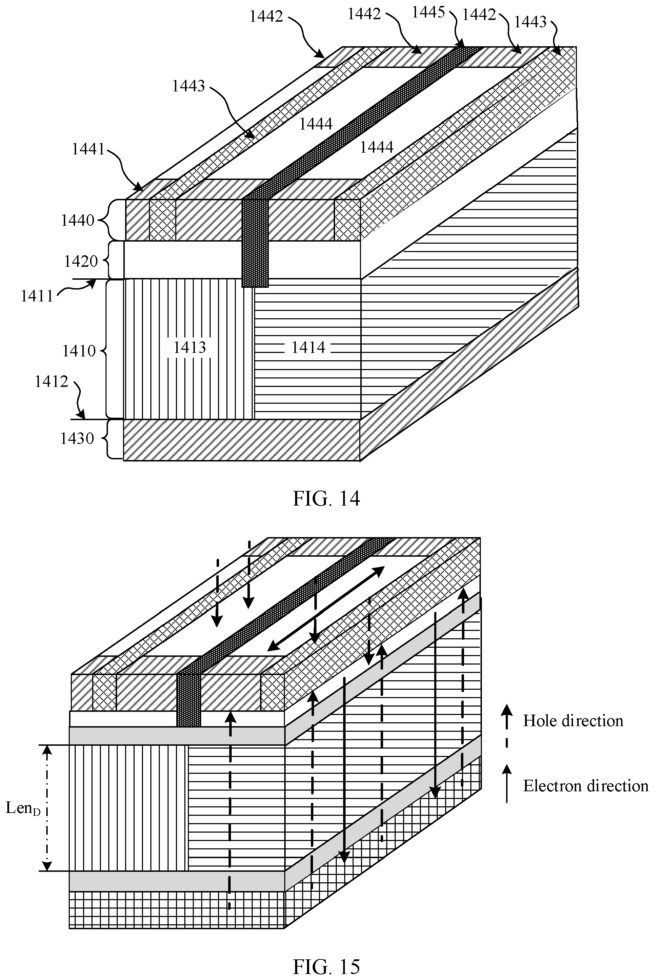

FIG. 14 is a diagram of another semiconductor device according to an embodiment of this application.

The semiconductor device shown in FIG. 14 includes a first semiconductor layer 1410, a second semiconductor layer 1420, a third semiconductor layer 1430, and a fourth semiconductor layer 1440.

The first semiconductor layer 1410 includes a region 1414 (which may also be referred to as a second pillar 1414) whose conductivity type is a first conductivity type and a pillar 1413 (which may also be referred to as a first pillar 1413) whose conductivity type is a second conductivity type. The region 1414 and the pillar 1413 are arranged in a first direction, the first direction is perpendicular to a second direction, and the second direction is a thickness direction of the semiconductor device.

The second semiconductor layer 1420 is located above a first surface 1411 of the first semiconductor layer 1410, and the third semiconductor layer 1430 is located below a second surface 1412 of the first semiconductor layer 1410.

A conductivity type of the second semiconductor layer 1420 is the second conductivity type, and a conductivity type of the third semiconductor layer is the first conductivity type.

The fourth semiconductor layer 1440 is disposed on a surface of the second semiconductor layer 1420 facing away from the first semiconductor layer 1410. The fourth semiconductor layer 1440 includes a first semiconductor region 1441, a second semiconductor region 1442, a third semiconductor region 1443, a fourth semiconductor region 1444, and a conductive material region 1445.

It can be learned that, compared with the semiconductor device each shown in FIG. 10 and FIG. 11, the semiconductor device shown in FIG. 14 does not include a buffer layer (that is, a fifth semiconductor layer 1050) between the second semiconductor layer and the first semiconductor layer and a buffer layer (that is, a sixth semiconductor layer 1060) between the first semiconductor layer and the third semiconductor layer. In addition, other parts of these two semiconductor devices are disposed in a same manner. For brevity, details are not described herein again.

In the semiconductor device each shown in FIG. 10 to FIG. 14, conductive material regions located in the fourth semiconductor layer are all at a same potential as a gate. In some other embodiments, the fourth semiconductor layer may further include a conductive material region that is at a same potential as an emitter. In other words, the fourth semiconductor layer may include the conductive material region that is at the same potential as the emitter and the conductive material region that is at the same potential as the gate. Two adjacent conductive material regions are disposed in parallel and are parallel to a third direction.

FIG. 15 shows a hole direction and an electron direction of the semiconductor device shown in FIG. 11. As shown in FIG. 15, electrons are injected upward from the bottom of a MOSFET region. After being injected into the fourth semiconductor layer, the electrons continue to be injected into the first semiconductor region and the second semiconductor region that are disposed in parallel. Therefore, a transmission path of the electrons is longer than a side length of a drift region (that is, Len_{D} in FIG. 15). In this case, a transverse voltage drop is generated. The transverse voltage drop causes a PN junction of a channel substrate (channel substrate, CS) layer to be forward-biased. A hole is injected from a fourth semiconductor region between the first semiconductor region and the second semiconductor region that are disposed in parallel, so that a body diode in the MOSFET region exhibits a lower voltage drop in a synchronous rectification mode. This can improve synchronous rectification performance of the semiconductor device.

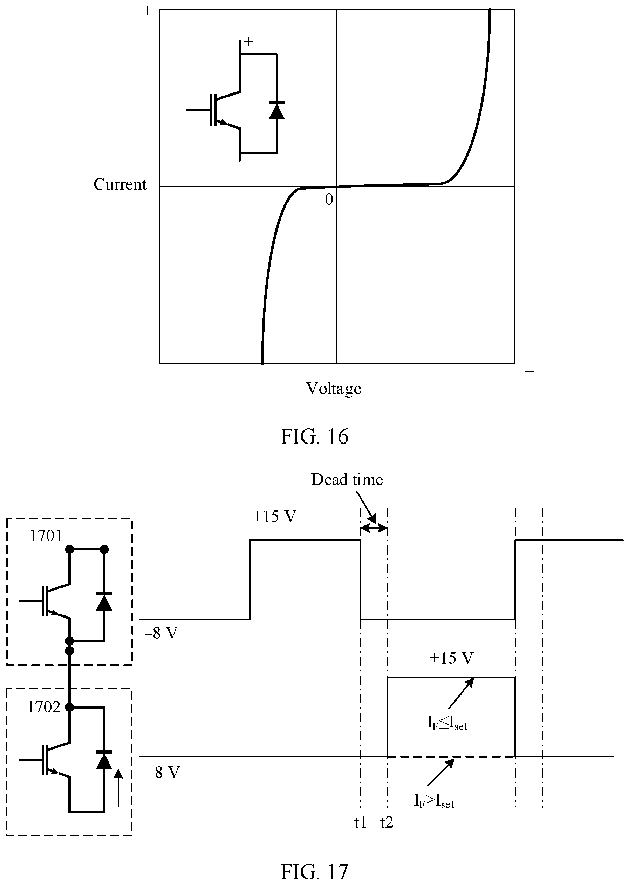

FIG. 16 is a volt-ampere characteristic curve of the body diode in the MOSFET region in the semiconductor device shown in FIG. 11. It can be learned from FIG. 16 that when a voltage is less than 0, the voltage drop is small.

An embodiment of this application further provides a control method. The control method may be used for controlling a circuit including the semiconductor device in the foregoing embodiments. The method includes: monitoring, when a current direction of the semiconductor device is from an emitter to a collector, a current value of a main current of the semiconductor device at dead time; and keeping a gate of the semiconductor device in an off state when the current value of the main current is greater than a preset value; or turning on the gate of the semiconductor device after the dead time when the current value of the main current is less than or equal to the preset value. According to the method, a smaller reverse voltage in a bidirectional mode and a unidirectional mode can be selected, thereby reducing a power loss in a reverse conduction state.

FIG. 17 is a diagram of a control method according to an embodiment of this application.

A semiconductor device 1701 and a semiconductor device 1702 shown in FIG. 17 are equivalent circuit diagrams of the semiconductor device according to an embodiment of this application. It is assumed that a current direction of the semiconductor device 1702 is from an emitter to a collector. In this case, a current value of a main current (that is, I_{F}) of the semiconductor device 1702 at dead time may be monitored (that is, monitoring starts to be performed from a moment t1). If the value of the main current is greater than a preset value (that is, Iₛₑₜ), the semiconductor device 1702 is kept in an off state (that is, a bidirectional mode). If the value of the main current is less than or equal to the preset value, after the dead time (that is, a moment t2), a gate of the semiconductor device 1702 is turned on (that is, a unidirectional mode).

An embodiment of this application further provides a control method. The control method may be used for controlling a circuit including the semiconductor device in the foregoing embodiments. The method includes: determining a first voltage value and a second voltage value when a current direction of the semiconductor device is from an emitter to a collector, where the first voltage value is a voltage value of a terminal voltage of the semiconductor device at dead time, and the second voltage value is a voltage value of the terminal voltage after a gate of the semiconductor device is turned on; and turning off the gate of the semiconductor device when a difference between the second voltage value and the first voltage value is greater than a preset value; or keeping the gate of the semiconductor device in an on state when the difference between the second voltage value and the first voltage value is not greater than the preset value. According to the method, a smaller reverse voltage in a bidirectional mode and a unidirectional mode can be selected, thereby reducing a power loss in a reverse conduction state.

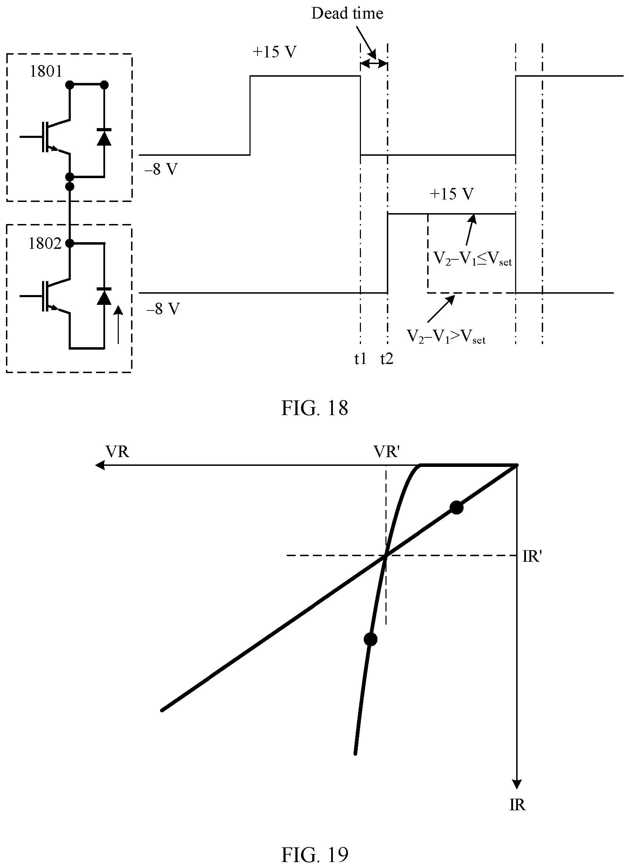

FIG. 18 is a diagram of a control method according to an embodiment of this application.

A semiconductor device 1801 and a semiconductor device 1802 shown in FIG. 18 are equivalent circuit diagrams of the semiconductor device according to an embodiment of this application. It is assumed that a current direction of the semiconductor device 1802 is from an emitter to a collector. In this case, a voltage value (that is, V₁) of a terminal voltage of the semiconductor device 1802 at dead time and a voltage value (that is, V₂) of the terminal voltage of the semiconductor device 1802 after a gate of the semiconductor device is turned on may be monitored. If V₂-V₁ is greater than a preset value (that is, Vₛₑₜ), the gate of the semiconductor device 1802 is turned off (that is, a bidirectional mode). If V₂-V₁ is not greater than Vₛₑₜ, after the dead time (that is, a moment t2), the gate of the semiconductor device 1802 is kept in an on state (that is, a unidirectional mode).

FIG. 19 shows an IR-VR characteristic curve of the semiconductor element according to the technical solution of this application.

As shown in FIG. 19, when a current is greater than IR' or a voltage is greater than VR', a smaller reverse voltage can be kept in the bidirectional mode. When the current is less than IR' or the voltage is less than VR', a smaller reverse voltage can be kept in the unidirectional mode.

An embodiment of this application further provides a manufacturing method for a semiconductor device. The manufacturing method is used for manufacturing any one of the foregoing semiconductor devices.

In some embodiments, the semiconductor device manufactured in the manufacturing method is divided, in a first direction, into an IGBT region for forming an insulated-gate bipolar transistor IGBT, a diode region for forming a diode, and a MOSFET region for forming a metal-oxide-semiconductor field-effect transistor MOSFET. The manufacturing method includes: manufacturing a first semiconductor layer, where a conductivity type of the first semiconductor layer is a first conductivity type, the first semiconductor layer includes a plurality of pillars, the plurality of pillars are arranged in the first direction, the first direction is perpendicular to a thickness direction of the semiconductor device, and a conductivity type of the pillar is a second conductivity type; manufacturing a second semiconductor layer, where the second semiconductor layer is located above the first semiconductor layer, and a conductivity type of the second semiconductor layer is the second conductivity type; manufacturing a third semiconductor layer, where the third semiconductor layer is located below the first semiconductor layer and is located in the diode region and the MOSFET region, and a conductivity type of the third semiconductor layer is the first conductivity type; manufacturing a fourth semiconductor layer, where the fourth semiconductor layer is located below the first semiconductor layer and is located in the IGBT region, and a conductivity type of the fourth semiconductor layer is the second conductivity type; and manufacturing at least one first conductive material region, where the at least one first conductive material region is located in the diode region.

Optionally, the manufacturing method further includes manufacturing at least one first semiconductor region, at least one second semiconductor region, at least one second conductive material region, and at least one third conductive material region, where the at least one third conductive material region and the at least one first semiconductor region are located in the IGBT region; the at least one second conductive material region and the at least one second semiconductor region are located in the MOSFET region; and a conductivity type of the first semiconductor region and a conductivity type of the second semiconductor region are the first conductivity type.

Optionally, the manufacturing method further includes manufacturing at least one fourth conductive material region, where the at least one fourth conductive material region is located in the IGBT region.

Optionally, the manufacturing method further includes manufacturing at least one fifth conductive material region, where the at least one fifth conductive material region is located in the MOSFET region.

Optionally, the IGBT region, the diode region, and the MOSFET region are sequentially arranged in the first semiconductor layer in the first direction.

Optionally, the MOSFET region includes a first MOSFET region and a second MOSFET region, and the IGBT region, the first MOSFET region, the diode region, and the second MOSFET region are sequentially arranged in the first semiconductor layer in the first direction.

Optionally, the manufacturing method further includes manufacturing at least one floating region, where the at least one floating region is in one-to-one correspondence with at least one of the pillars, and the floating region penetrates the second semiconductor layer and is in contact with the corresponding pillar.

Optionally, manufacturing the third conductive material region includes forming a third trench, where the third trench penetrates the second semiconductor layer and is in contact with a first semiconductor layer and/or a pillar that are/is located in the IGBT region, and the third trench is filled with a third conductive material; manufacturing the second conductive material region includes forming a second trench, where the second trench penetrates the second semiconductor layer and is in contact with a first semiconductor layer and/or a pillar that are/is located in the MOSFET region, and the second trench is filled with a second conductive material; and manufacturing the first conductive material region includes forming a first trench, where the first trench penetrates the second semiconductor layer and is in contact with a first semiconductor layer and/or a pillar that are/is located in the diode region, and the first trench is filled with a first conductive material.

Optionally, the first semiconductor region and the second semiconductor region are manufactured in a region of the second semiconductor layer facing away from the first semiconductor layer.

In some other embodiments, the semiconductor device manufactured in the manufacturing method is divided, in a first direction, into an IGBT region for forming an insulated-gate bipolar transistor IGBT and a MOSFET region for forming a metal-oxide-semiconductor field-effect transistor MOSFET, where the first direction, a second direction, and a third direction are perpendicular to each other, and the second direction is a thickness direction of the semiconductor device. The manufacturing method includes: manufacturing a first semiconductor layer, where the first semiconductor layer is located in the MOSFET region, a conductivity type of the first semiconductor layer is a first conductivity type, the first semiconductor layer includes a plurality of pillars, the plurality of pillars are arranged in the first direction, and a conductivity type of the pillar is a second conductivity type; manufacturing a second semiconductor layer, where the second semiconductor layer is located in the MOSFET region, a conductivity type of the second semiconductor layer is the second conductivity type, and the second semiconductor layer is disposed above the first semiconductor layer; manufacturing a third semiconductor layer, where the third semiconductor layer is located in the MOSFET region, a conductivity type of the third semiconductor layer is the first conductivity type, and the third semiconductor layer is disposed below the first semiconductor layer; and manufacturing a fourth semiconductor layer, where the fourth semiconductor layer is located in the MOSFET region, the fourth semiconductor layer is disposed on a surface of the second semiconductor layer facing away from the first semiconductor layer. The fourth semiconductor layer includes a first semiconductor region and a second semiconductor region that are disposed in parallel on two sides of the fourth semiconductor layer, a plurality of conductive material regions that are disposed in parallel, and a plurality of third semiconductor regions that are disposed in parallel, where the first semiconductor region and the second semiconductor region are parallel to the first direction, and a conductivity type of the first semiconductor region and a conductivity type of the second semiconductor region are the first conductivity type; the conductive material region is parallel to the third direction; and the third semiconductor region is parallel to the third direction, and a conductivity type of the third semiconductor region is the second conductivity type. The fourth semiconductor layer further includes a fourth semiconductor region, the fourth semiconductor region is located between the third semiconductor region and the conductive material region, and a conductivity type of the fourth semiconductor region is the second conductivity type.

Optionally, the first semiconductor region is divided into a plurality of first sub-semiconductor regions by the plurality of third semiconductor regions that are disposed in parallel and the plurality of conductive material regions that are disposed in parallel; and the second semiconductor region is divided into a plurality of second sub-semiconductor regions by the plurality of third semiconductor regions that are disposed in parallel and the plurality of conductive material regions that are disposed in parallel.

Optionally, manufacturing the conductive material region includes forming a trench, where the trench penetrates the second semiconductor layer, and the trench is filled with a conductive material.

Optionally, manufacturing the fourth semiconductor layer includes: doping an impurity at a first concentration in the third semiconductor region; and doping an impurity at a second concentration in the fourth semiconductor region, where the first concentration is different from the second concentration.

In some embodiments, the manufacturing method further includes manufacturing a fifth semiconductor layer, where the fifth semiconductor layer is located in the MOSFET region, a conductivity type of the fifth semiconductor layer is the first conductivity type, and the fifth semiconductor layer is located between the first semiconductor layer and the second semiconductor layer.

In some embodiments, the manufacturing method further includes manufacturing a sixth semiconductor layer, where the sixth semiconductor layer is located between the first semiconductor layer and the third semiconductor layer, and a conductivity type of the sixth semiconductor layer is the first conductivity type.

An embodiment of this application further provides a power conversion circuit. The power conversion circuit includes at least any one or more of the foregoing semiconductor devices.

An embodiment of this application further provides an inverter or an inverter circuit. The inverter or the inverter circuit includes at least any one or more of the foregoing semiconductor devices.

An embodiment of this application further provides a chip. The chip includes at least any one or more of the foregoing semiconductor devices.

An embodiment of this application further provides an electronic device. In some embodiments, the electronic device includes at least any one or more of the foregoing semiconductor devices. In some other embodiments, the electronic device includes the foregoing power conversion circuit. In some other embodiments, the electronic device includes the foregoing inverter or inverter circuit. In some other embodiments, the electronic device includes the foregoing chip.

An embodiment of this application further provides a transportation means. In some embodiments, the transportation means includes any one or more of the foregoing semiconductor devices. In some other embodiments, the transportation means includes the foregoing power conversion circuit. In some other embodiments, the transportation means includes the foregoing inverter or inverter circuit. In some other embodiments, the transportation means includes the foregoing chip. The transportation means may be a vehicle, an electric bicycle, or the like. The vehicle may be an electric vehicle, a hybrid vehicle, or the like.

An embodiment of this application further provides a power apparatus. In some embodiments, the power apparatus includes any one or more of the foregoing semiconductor devices. In some other embodiments, the power apparatus includes the foregoing power conversion circuit. In some other embodiments, the power apparatus includes the foregoing inverter or inverter circuit. In some other embodiments, the power apparatus includes the foregoing chip. The power apparatus may be a solar power apparatus (for example, a solar power generation apparatus, a photovoltaic pump, or a solar signal light), a charging pile, a charger, or the like.

According to the method provided in embodiments of this application, this application further provides a computer program product. The computer program product includes computer program code. When the computer program code is run on a computer, the computer is caused to perform the steps in the foregoing embodiments.

According to the method provided in embodiments of this application, this application further provides a computer-readable medium. The computer-readable medium stores program code. When the program code is run on a computer, the computer is caused to perform the steps in the foregoing embodiments.

According to the method provided in embodiments of this application, an embodiment of this application provides a chip system. The chip system includes a logic circuit. The logic circuit is configured to be coupled to an input/output interface, and transmit data through the input/output interface, to perform the steps in the foregoing embodiments.

An embodiment of this application provides an electronic device. The electronic device includes a processor and a memory. The processor may be a chip. For example, the processor may be a field programmable gate array (field programmable gate array, FPGA), an application-specific integrated chip (application-specific integrated circuit, ASIC), a graphics processing unit (graphics processing unit, GPU), a system on a chip (system on a chip, SoC), a central processing unit (central processing unit, CPU), a network processor (network processor, NP), a digital signal processing circuit (digital signal processor, DSP), a microcontroller (microcontroller unit, MCU), a programmable controller (programmable logic device, PLD), another programmable logic device, a discrete gate or a transistor logic device, a discrete hardware component, or another integrated chip.

In an implementation process, the steps of the foregoing methods can be completed by using a hardware integrated logic circuit in a processor or by using instructions in a form of software. The steps of the methods disclosed with reference to embodiments of this application may be directly performed and completed by a hardware processor, or may be performed and completed by using a combination of hardware in the processor and a software module. The software module may be located in a mature storage medium in the art, such as a random access memory, a flash memory, a read-only memory, a programmable read-only memory, an electrically erasable programmable memory, or a register. The storage medium is located in a memory, and a processor reads information in the memory and completes the steps of the foregoing methods in combination with hardware of the processor. To avoid repetition, details are not described herein again.

It should be noted that the processor in embodiments of this application may be an integrated circuit chip, and has a signal processing capability. In an implementation process, the steps in the foregoing method embodiments can be completed by using a hardware integrated logic circuit in a processor or by using instructions in a form of software. A general-purpose processor may be a microprocessor, or the processor may be any conventional processor or the like. The steps of the methods disclosed with reference to embodiments of this application may be directly performed and completed by a hardware decoding processor, or may be performed and completed by using a combination of hardware in the decoding processor and a software module. The software module may be located in a mature storage medium in the art, such as a random access memory, a flash memory, a read-only memory, a programmable read-only memory, an electrically erasable programmable memory, or a register. The storage medium is located in a memory, and a processor reads information in the memory and completes the steps of the foregoing methods in combination with hardware of the processor.

It may be understood that the memory in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through example but not limitative description, many forms of RAMs may be used, such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that memories of the systems and methods described in this specification include but are not limited to these memories and any other suitable types of memories.

A person of ordinary skill in the art may be aware that in combination with the examples described in embodiments disclosed in this specification, units and algorithm steps can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that for the purpose of convenient and brief description, for a specific working process of the foregoing systems, apparatuses, and units, refer to a corresponding process in the foregoing method embodiments. Details are not described herein again.

In the several embodiments provided in this application, it should be understood that the disclosed systems, apparatuses, and methods may be implemented in other manners. For example, the apparatus embodiments described above are merely examples. For example, unit division is merely logical function division, and there may be another division manner in an actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located at one position, or may be distributed on a plurality of network units. A part or all of the units may be selected based on an actual requirement to achieve the objectives of the solutions of the embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, the part contributing to a conventional technology, or a part of the technical solutions may be implemented in a form of a software product. The computer software product is stored in a storage medium, and includes several instructions for instructing a computer device (which may be a personal computer, a server, a network device, or the like) to perform all or a part of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising a first semiconductor layer and a second semiconductor layer, wherein
a conductivity type of the first semiconductor layer is a first conductivity type, the first semiconductor layer comprises a plurality of pillars, the plurality of pillars are arranged in a first direction, the first direction is perpendicular to a thickness direction of the semiconductor device, and a conductivity type of the pillar is a second conductivity type;
the second semiconductor layer is disposed above the first semiconductor layer, and a conductivity type of the second semiconductor layer is the second conductivity type; and
the semiconductor device is divided, in the first direction, into an IGBT region for forming an insulated-gate bipolar transistor IGBT, a diode region for forming a diode, and a MOSFET region for forming a metal-oxide-semiconductor field-effect transistor MOSFET;
the semiconductor device further comprises a third semiconductor layer and a fourth semiconductor layer, wherein
the third semiconductor layer is disposed below the first semiconductor layer and is located in the diode region and the MOSFET region, and a conductivity type of the third semiconductor layer is the first conductivity type; and
the fourth semiconductor layer is disposed below the first semiconductor layer and is located in the IGBT region, and a conductivity type of the fourth semiconductor layer is the second conductivity type; and
the semiconductor device further comprises at least one first conductive material region, and the at least one first conductive material region is located in the diode region.

2. The semiconductor device according to claim 1, wherein the semiconductor device further comprises at least one first semiconductor region, at least one second semiconductor region, at least one second conductive material region, and at least one third conductive material region, wherein
the at least one third conductive material and the at least one first semiconductor region are located in the IGBT region;
the at least one second conductive material region and the at least one second semiconductor region are located in the MOSFET region; and
a conductivity type of the first semiconductor region and a conductivity type of the second semiconductor region are the first conductivity type.

3. The semiconductor device according to claim 2, wherein
the first conductive material region comprises a first trench, the first trench is filled with a first conductive material, and the first trench penetrates the second semiconductor layer and is in contact with a first semiconductor layer and/or a pillar that are/is located in the diode region;
the second conductive material region comprises a second trench, the second trench is filled with a second conductive material, and the second trench penetrates the second semiconductor layer and is in contact with a first semiconductor layer and/or a pillar that are/is located in the MOSFET region; and
the third conductive material region comprises a third trench, the third trench is filled with a third conductive material, and the third trench penetrates the second semiconductor layer and is in contact with a first semiconductor layer and/or a pillar that are/is located in the IGBT region.

4. The semiconductor device according to any one of claims 1 to 3, wherein the semiconductor device further comprises at least one fourth conductive material region, and the at least one fourth conductive material region is located in the IGBT region.

5. The semiconductor device according to any one of claims 1 to 4, wherein the semiconductor device further comprises at least one fifth conductive material region, and the at least one fifth conductive material region is located in the MOSFET region.

6. The semiconductor device according to any one of claims 1 to 5, wherein the IGBT region, the diode region, and the MOSFET region are sequentially arranged in the first semiconductor layer in the first direction.

7. The semiconductor device according to any one of claims 1 to 6, wherein the MOSFET region comprises a first MOSFET region and a second MOSFET region, and the IGBT region, the first MOSFET region, the diode region, and the second MOSFET region are sequentially arranged in the first semiconductor layer in the first direction.

8. The semiconductor device according to any one of claims 1 to 7, wherein the semiconductor device further comprises at least one floating region, the at least one floating region is in one-to-one correspondence with at least one of the pillars, and the floating region penetrates the second semiconductor layer and is in contact with the corresponding pillar.

9. The semiconductor device according to any one of claims 2 to 8, wherein the first semiconductor region and the second semiconductor region are located in a region of the second semiconductor layer facing away from the first semiconductor layer.

10. A semiconductor device, wherein the semiconductor device is divided, in a first direction, into an IGBT region for forming an insulated-gate bipolar transistor IGBT and a MOSFET region for forming a metal-oxide-semiconductor field-effect transistor MOSFET, the first direction, a second direction, and a third direction are perpendicular to each other, and the second direction is a thickness direction of the semiconductor device; and
the MOSFET region comprises a first semiconductor layer, a second semiconductor layer, a third semiconductor layer, and a fourth semiconductor layer, wherein
a conductivity type of the first semiconductor layer is a first conductivity type, the first semiconductor layer comprises a plurality of pillars, the plurality of pillars are arranged in the first direction, and a conductivity type of the pillar is a second conductivity type;
a conductivity type of the second semiconductor layer is the second conductivity type, and the second semiconductor layer is disposed above the first semiconductor layer;
a conductivity type of the third semiconductor layer is the first conductivity type, and the third semiconductor layer is disposed below the first semiconductor layer;
the fourth semiconductor layer is disposed on a surface of the second semiconductor layer facing away from the first semiconductor layer, and the fourth semiconductor layer comprises a first semiconductor region and a second semiconductor region that are disposed in parallel on two sides of the fourth semiconductor layer, a plurality of conductive material regions that are disposed in parallel, and a plurality of third semiconductor regions that are disposed in parallel, wherein
the first semiconductor region and the second semiconductor region are parallel to the first direction, and a conductivity type of the first semiconductor region and a conductivity type of the second semiconductor region are the first conductivity type;
the conductive material region is parallel to the third direction; and
the third semiconductor region is parallel to the third direction, and a conductivity type of the third semiconductor region is the second conductivity type; and
the fourth semiconductor layer further comprises a fourth semiconductor region, the fourth semiconductor region is located between the third semiconductor region and the conductive material region, and a conductivity type of the fourth semiconductor region is the second conductivity type.

11. The semiconductor device according to claim 10, wherein the first semiconductor region is divided into a plurality of first sub-semiconductor regions by the plurality of third semiconductor regions that are disposed in parallel and the plurality of conductive material regions that are disposed in parallel; and
the second semiconductor region is divided into a plurality of second sub-semiconductor regions by the plurality of third semiconductor regions that are disposed in parallel and the plurality of conductive material regions that are disposed in parallel.

12. The semiconductor device according to claim 10 or 11, wherein the conductive material region comprises a trench, the trench is filled with a conductive material, and the trench penetrates the second semiconductor layer.

13. The semiconductor device according to any one of claims 10 to 12, wherein an impurity concentration of the third semiconductor region is different from an impurity concentration of the fourth semiconductor region.

14. The semiconductor device according to any one of claims 10 to 13, wherein the MOSFET region further comprises a fifth semiconductor layer, a conductivity type of the fifth semiconductor layer is the first conductivity type, and the fifth semiconductor layer is located between the first semiconductor layer and the second semiconductor layer.

15. The semiconductor device according to any one of claims 10 to 14, wherein the semiconductor device further comprises a sixth semiconductor layer, the sixth semiconductor layer is located between the first semiconductor layer and the third semiconductor layer, and a conductivity type of the sixth semiconductor layer is the first conductivity type.

16. A power conversion circuit, comprising at least one semiconductor device according to any one of claims 1 to 15.

17. A chip, comprising at least one semiconductor device according to any one of claims 1 to 15.

18. An electronic device, comprising at least one semiconductor device according to any one of claims 1 to 15.

19. A control method, wherein the method comprises:
monitoring, when a current direction of the semiconductor device according to any one of claims 1 to 15 is from an emitter to a collector, a current value of a main current of the semiconductor device at dead time; and
keeping a gate of the semiconductor device in an off state when the current value of the main current is greater than a preset value; or
turning on the gate of the semiconductor device after the dead time when the current value of the main current is less than or equal to the preset value.

20. A control method, wherein the method comprises:
determining a first voltage value and a second voltage value when a current direction of the semiconductor device according to any one of claims 1 to 15 is from an emitter to a collector, wherein the first voltage value is a voltage value of a terminal voltage of the semiconductor device at dead time, and the second voltage value is a voltage value of the terminal voltage after a gate of the semiconductor device is turned on; and
turning off the gate of the semiconductor device when a difference between the second voltage value and the first voltage value is greater than a preset value; or
keeping the gate of the semiconductor device in an on state when the difference between the second voltage value and the first voltage value is not greater than the preset value.

21. A manufacturing method for a semiconductor device, comprising: dividing, in a first direction, the semiconductor device into an IGBT region for forming an insulated-gate bipolar transistor IGBT, a diode region for forming a diode, and a MOSFET region for forming a metal-oxide-semiconductor field-effect transistor MOSFET;
manufacturing a first semiconductor layer, wherein a conductivity type of the first semiconductor layer is a first conductivity type, the first semiconductor layer comprises a plurality of pillars, the plurality of pillars are arranged in the first direction, the first direction is perpendicular to a thickness direction of the semiconductor device, and a conductivity type of the pillar is a second conductivity type;
manufacturing a second semiconductor layer, wherein the second semiconductor layer is located above the first semiconductor layer, and a conductivity type of the second semiconductor layer is the second conductivity type;
manufacturing a third semiconductor layer, wherein the third semiconductor layer is located below the first semiconductor layer and is located in the diode region and the MOSFET region, and a conductivity type of the third semiconductor layer is the first conductivity type;
manufacturing a fourth semiconductor layer, wherein the fourth semiconductor layer is located below the first semiconductor layer and is located in the IGBT region, and a conductivity type of the fourth semiconductor layer is the second conductivity type; and
manufacturing at least one first conductive material region, wherein the at least one first conductive material region is located in the diode region.

22. The manufacturing method according to claim 21, wherein the method further comprises manufacturing at least one first semiconductor region, at least one second semiconductor region, at least one second conductive material region, and at least one third conductive material region, wherein
the at least one third conductive material region and the at least one first semiconductor region are located in the IGBT region;
the at least one second conductive material region and the at least one second semiconductor region are located in the MOSFET region; and
a conductivity type of the first semiconductor region and a conductivity type of the second semiconductor region are the first conductivity type.

23. The manufacturing method according to claim 21 or 22, wherein the method further comprises manufacturing at least one fourth conductive material region, wherein the at least one fourth conductive material region is located in the IGBT region.

24. The manufacturing method according to any one of claims 21 to 23, wherein the method further comprises manufacturing at least one fifth conductive material region, wherein the at least one fifth conductive material region is located in the MOSFET region.

25. The manufacturing method according to any one of claims 21 to 24, wherein the IGBT region, the diode region, and the MOSFET region are sequentially arranged in the first semiconductor layer in the first direction.

26. The manufacturing method according to any one of claims 21 to 25, wherein the MOSFET region comprises a first MOSFET region and a second MOSFET region, and the IGBT region, the first MOSFET region, the diode region, and the second MOSFET region are sequentially arranged in the first semiconductor layer in the first direction.

27. The manufacturing method according to any one of claims 21 to 26, wherein the method further comprises manufacturing at least one floating region, wherein the at least one floating region is in one-to-one correspondence with at least one of the pillars, and the floating region penetrates the second semiconductor layer and is in contact with the corresponding pillar.

28. A manufacturing method for a semiconductor device, comprising: dividing, in a first direction, the semiconductor device into an IGBT region for forming an insulated-gate bipolar transistor IGBT and a MOSFET region for forming a metal-oxide-semiconductor field-effect transistor MOSFET, wherein the first direction, a second direction, and a third direction are perpendicular to each other, and the second direction is a thickness direction of the semiconductor device;
manufacturing a first semiconductor layer, wherein the first semiconductor layer is located in the MOSFET region, a conductivity type of the first semiconductor layer is a first conductivity type, the first semiconductor layer comprises a plurality of pillars, the plurality of pillars are arranged in the first direction, and a conductivity type of the pillar is a second conductivity type;
manufacturing a second semiconductor layer, wherein the second semiconductor layer is located in the MOSFET region, a conductivity type of the second semiconductor layer is the second conductivity type, and the second semiconductor layer is disposed above the first semiconductor layer;
manufacturing a third semiconductor layer, wherein the third semiconductor layer is located in the MOSFET region, a conductivity type of the third semiconductor layer is the first conductivity type, and the third semiconductor layer is disposed below the first semiconductor layer; and
manufacturing a fourth semiconductor layer, wherein the fourth semiconductor layer is located in the MOSFET region, the fourth semiconductor layer is disposed on a surface of the second semiconductor layer facing away from the first semiconductor layer, and the fourth semiconductor layer comprises a first semiconductor region and a second semiconductor region that are disposed in parallel on two sides of the fourth semiconductor layer, a plurality of conductive material regions that are disposed in parallel, and a plurality of third semiconductor regions that are disposed in parallel, wherein
the first semiconductor region and the second semiconductor region are parallel to the first direction, and a conductivity type of the first semiconductor region and a conductivity type of the second semiconductor region are the first conductivity type;
the conductive material region is parallel to the third direction; and
the third semiconductor region is parallel to the third direction, and a conductivity type of the third semiconductor region is the second conductivity type; and
the fourth semiconductor layer further comprises a fourth semiconductor region, the fourth semiconductor region is located between the third semiconductor region and the conductive material region, and a conductivity type of the fourth semiconductor region is the second conductivity type.

29. The manufacturing method according to claim 28, wherein the first semiconductor region is divided into a plurality of first sub-semiconductor regions by the plurality of third semiconductor regions that are disposed in parallel and the plurality of conductive material regions that are disposed in parallel; and
the second semiconductor region is divided into a plurality of second sub-semiconductor regions by the plurality of third semiconductor regions that are disposed in parallel and the plurality of conductive material regions that are disposed in parallel.

30. The manufacturing method according to claim 28 or 29, wherein manufacturing the conductive material region comprises forming a trench, wherein the trench penetrates the second semiconductor layer, and the trench is filled with a conductive material.

31. The manufacturing method according to any one of claims 28 to 30, wherein manufacturing the fourth semiconductor layer comprises:
doping an impurity at a first concentration in the third semiconductor region; and
doping an impurity at a second concentration in the fourth semiconductor region, wherein the first concentration is different from the second concentration.

32. The manufacturing method according to any one of claims 28 to 31, wherein the method further comprises manufacturing a fifth semiconductor layer, wherein the fifth semiconductor layer is located in the MOSFET region, a conductivity type of the fifth semiconductor layer is the first conductivity type, and the fifth semiconductor layer is located between the first semiconductor layer and the second semiconductor layer.

33. The manufacturing method according to any one of claims 28 to 32, wherein the method further comprises manufacturing a sixth semiconductor layer, wherein the sixth semiconductor layer is located between the first semiconductor layer and the third semiconductor layer, and a conductivity type of the sixth semiconductor layer is the first conductivity type.
